# EUROPEAN PATENT APPLICATION

(11) **EP 4 617 778 A1**
(43) Date of publication of application: **17.09.2025**
(21) Application number: 23894463.1
(22) Date of filing: 13.11.2023
(51) Int. Cl.: G03F 7/36, H01L 21/3065

(54) **DRY DEVELOPING METHOD AND DRY DEVELOPING DEVICE**

(30) Priority: 25.11.2022 US 202263427956 P; 03.04.2023 JP 2023059944
(71) Applicant: Tokyo Electron Limited, Tokyo 107-6325 (JP)
(72) Inventor: NAKANE, Yuta, Kurokawa-gun, Miyagi 981-3629 (JP); KUMAKURA, Sho, Kurokawa-gun, Miyagi 981-3629 (JP)
(74) Representative: Piotrowicz, Pawel Jan Andrzej
(86) International application number: PCT/JP2023/040723
(87) International publication number: WO 2024/111454

(57) **Abstract**

A dry development method includes (a) providing a substrate on a substrate support in a chamber, substrate including an underlying film and a metal-containing resist on the underlying film, the metal-containing resist including an exposed first region and an unexposed second region, (b) supplying a first processing gas including a fluorine-containing gas into the chamber to form a metal fluoride layer on a surface of the second region, and (c) supplying a second processing gas including a chlorine-containing gas into the chamber to remove the metal fluoride layer.

## Description

### Technical Field

An exemplary embodiment of the present disclosure relates to a dry development method and a dry development apparatus.

### Background Art

Patent Literature 1 discloses a technique for forming a metal-containing film that is patterned using extreme ultraviolet light (hereinafter, referred to as "EUV") on a semiconductor substrate. Patent Literature 1 discloses a technique for selectively removing an unexposed region which has not been exposed to EUV by using boron trichloride.

### Citation List

### Patent Literature

[Patent Literature 1] Japanese Unexamined Patent Publication No. 2021-523403

### Summary of Invention

### Technical Problem

The present disclosure provides a technique capable of appropriately developing a metal-containing resist.

### Solution to Problem

In one exemplary embodiment, a dry development method includes (a) providing a substrate on a substrate support in a chamber, in which the substrate includes an underlying film and a metal-containing resist on the underlying film, and the metal-containing resist has an exposed first region and an unexposed second region, (b) supplying a first processing gas including a fluorine-containing gas into the chamber to form a metal fluoride layer on a surface of the second region, and (c) supplying a second processing gas including a chlorine-containing gas into the chamber to remove the metal fluoride layer.

### Advantageous Effects of Invention

According to one exemplary embodiment, a technique is provided for appropriately developing a metal-containing resist.

### Brief Description of Drawings

FIG. 1 is a diagram schematically showing a dry development apparatus according to one exemplary embodiment.
FIG. 2 is a diagram schematically showing a dry development apparatus according to another exemplary embodiment.
FIG. 3 is a diagram schematically showing a dry development apparatus according to still another exemplary embodiment.
FIG. 4 is a flowchart of a dry development method according to one exemplary embodiment.
FIG. 5 is a cross-sectional view of an example of a substrate to which the method in FIG. 4 may be applied.
FIG. 6 is a cross-sectional view of another example of a substrate to which the method of FIG. 4 may be applied.
FIG. 7 is a cross-sectional view of still another example of a substrate to which the method of FIG. 4 may be applied.
FIG. 8 is a cross-sectional view showing a step of the dry development method according to one exemplary embodiment.
FIG. 9 is a cross-sectional view showing a step of the dry development method according to one exemplary embodiment.
FIG. 10 is a cross-sectional view showing a step of the dry development method according to one exemplary embodiment.
FIG. 11 is a diagram schematically showing a dry development apparatus according to still another exemplary embodiment.
FIG. 12 is a diagram schematically showing a dry development apparatus according to still another exemplary embodiment.
FIG. 13 is a diagram schematically showing a substrate support according to still another exemplary embodiment.
FIG. 14 is a flowchart of a dry development method according to still another exemplary embodiment.
FIG. 15 is a diagram showing an example of control of a flow rate of a first processing gas and a flow rate of a second processing gas.
FIG. 16 is a diagram showing another example of control of a flow rate of a first processing gas and a flow rate of a second processing gas.
FIG. 17 is a flowchart of a dry development method according to still another exemplary embodiment.
FIG. 18 is a diagram schematically showing a system for processing a substrate according to one exemplary embodiment.
FIG. 19 is a flowchart of a method for processing a substrate according to one exemplary embodiment.
FIG. 20 is a graph showing an example of a result of a first experiment.
FIG. 21 is a graph showing an example of a result of a second experiment.
FIG. 22 is a graph showing an example of a result of a third experiment.
FIG. 23 is a table showing an example of a result of a fourth experiment.

### Description of Embodiments

Hereinafter, various exemplary embodiments will be described in detail with reference to the drawings. In the drawing, the same or equivalent portions are denoted by the same reference signs.

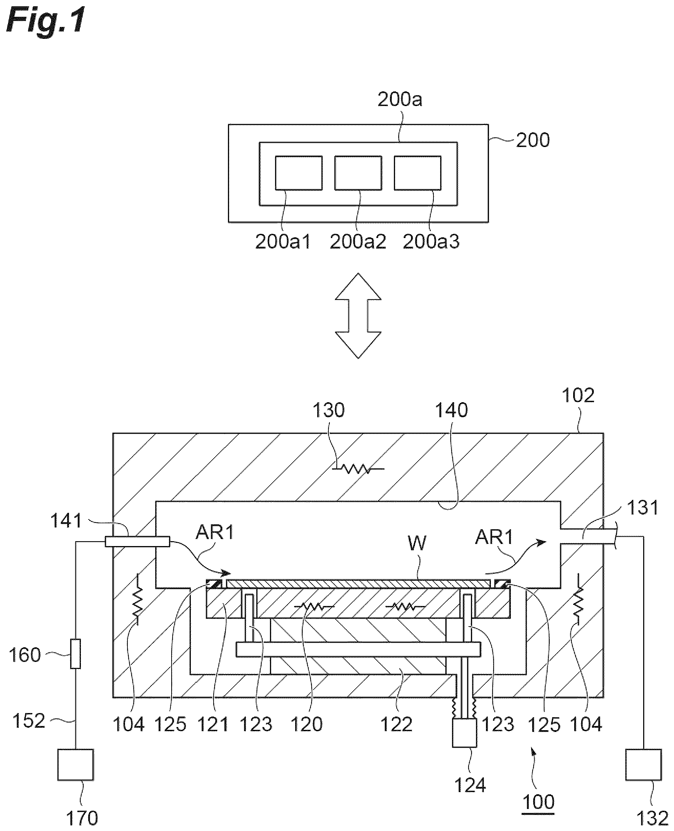

FIG. 1 is a diagram schematically showing a dry development apparatus according to one exemplary embodiment. In one exemplary embodiment, a heat treatment system includes a heat treatment apparatus 100 and a controller 200. The heat treatment system is an example of a dry development system. The heat treatment apparatus 100 is an example of a dry development apparatus.

The heat treatment apparatus 100 has a processing chamber 102 (chamber) that is configured to be sealable. The processing chamber 102 is, for example, an airtight cylindrical container, and is configured to be able to control the atmosphere inside. A side wall heater 104 is provided on a side wall of the processing chamber 102. A ceiling heater 130 is provided on a ceiling wall (top plate) of the processing chamber 102. A ceiling surface 140 of a ceiling wall (top plate) of the processing chamber 102 is formed as a horizontal flat surface, for example. A temperature of the ceiling surface 140 is controlled by the ceiling heater 130.

A substrate support 121 is provided on a lower side in the processing chamber 102. The substrate support 121 constitutes a placing portion on which a substrate W is placed. The substrate support 121 may have, for example, a circular surface (upper surface) or may have a surface (upper surface) formed horizontally. The substrate W is placed on a surface of the substrate support 121. A stage heater 120 is embedded in the substrate support 121. The stage heater 120 can heat the substrate W placed on the substrate support 121. A ring assembly 125 may be disposed on the substrate support 121 to surround the substrate W. The ring assembly 125 may include one or a plurality of annular members. By disposing the ring assembly 125, it is possible to improve the temperature controllability of an outer peripheral region of the substrate W. The ring assembly 125 may be made of inorganic materials or organic materials depending on the desired heat treatment.

The substrate support 121 is supported in the processing chamber 102 by a column 122 provided on a bottom surface of the processing chamber 102. A plurality of lift pins 123 that, for example, vertically move are provided on an outer side of the column 122 in a circumferential direction. The plurality of lift pins 123 are each inserted into a plurality of through-holes provided at intervals in the circumferential direction of the substrate support 121. The lifting operation of the lift pin 123 is controlled by a lift mechanism 124. In a case where the lift pin 123 protrudes from the surface of the substrate support 121, the substrate W is delivered between a transport mechanism (not shown) and the substrate support 121.

An exhaust port 131 having an opening is provided on a side wall of the processing chamber 102. The exhaust port 131 is connected to an exhaust mechanism 132 via an exhaust pipe. The exhaust mechanism 132 is made of a vacuum pump, a valve, and the like, and adjusts an exhaust flow rate from the exhaust port 131. The pressure in the processing chamber 102 is adjusted by adjusting the exhaust flow rate and the like by means of the exhaust mechanism 132. A transport port (not shown) of the substrate W is formed to be openable and closable, on a side wall of the processing chamber 102 at a position different from a position of the exhaust port 131.

A gas nozzle 141 is provided at a position different from the positions of the exhaust port 131 and the transport port of the substrate W on the side wall of the processing chamber 102. The gas nozzle 141 supplies the processing gas into the processing chamber 102. The gas nozzle 141 is provided on a side opposite to the exhaust port 131 as viewed from a central portion of the substrate support 121, on the side wall of the processing chamber 102.

The gas nozzle 141 is formed in a rod shape that protrudes from the side wall of the processing chamber 102 toward the center of the processing chamber 102. A distal end of the gas nozzle 141 extends, for example, horizontally from the side wall of the processing chamber 102. The processing gas is discharged into the processing chamber 102 from a discharge port provided at the distal end of the gas nozzle 141. The discharged processing gas flows in a direction of an arrow AR1 shown in FIG. 1 and is discharged from the exhaust port 131. The distal end of the gas nozzle 141 may extend obliquely downward toward the substrate W, or may extend obliquely upward toward the ceiling surface 140 of the processing chamber 102.

The gas nozzle 141 may be provided, for example, on the ceiling wall of the processing chamber 102. The exhaust port 131 may be provided on the bottom surface of the processing chamber 102.

The heat treatment apparatus 100 has a gas supply pipe 152 connected to the gas nozzle 141 from the outer side of the processing chamber 102. A pipe heater 160 for heating an inside of the gas supply pipe 152 is provided around the gas supply pipe 152. The gas supply pipe 152 is connected to a gas supply 170. The gas supply 170 includes at least one gas source and at least one flow rate control device. The gas supply may include a vaporizer that vaporizes a gas source in a liquid state.

The controller 200 processes computer-executable instructions for causing the heat treatment apparatus 100 to execute various steps described in the present disclosure. The controller 200 may be configured to control each element of the heat treatment apparatus 100 to execute various steps described herein. In one embodiment, a part or all of the controller 200 may be included in the heat treatment apparatus 100. The controller 200 may include a processor 200a1, a storage 200a2, and a communication interface 200a3. The controller 200 is realized by, for example, a computer 200a. The processor 200a1 can be configured to read out a program from the storage 200a2 and execute the read out program to perform various control operations. This program may be stored in the storage 200a2 in advance, or may be acquired via the medium when necessary. The acquired program is stored in the storage 200a2, and is read out from the storage 200a2 and executed by the processor 200a1. The medium may be various storage media readable by the computer 200a, or may be a communication line connected to the communication interface 200a3. The processor 200a1 may be a central processing unit (CPU). The storage 200a2 may include a random access memory (RAM), a read only memory (ROM), a hard disk drive (HDD), a solid state drive (SSD), or combinations thereof. The communication interface 200a3 may be communicated with the heat treatment apparatus 100 via a communication line such as a local area network (LAN).

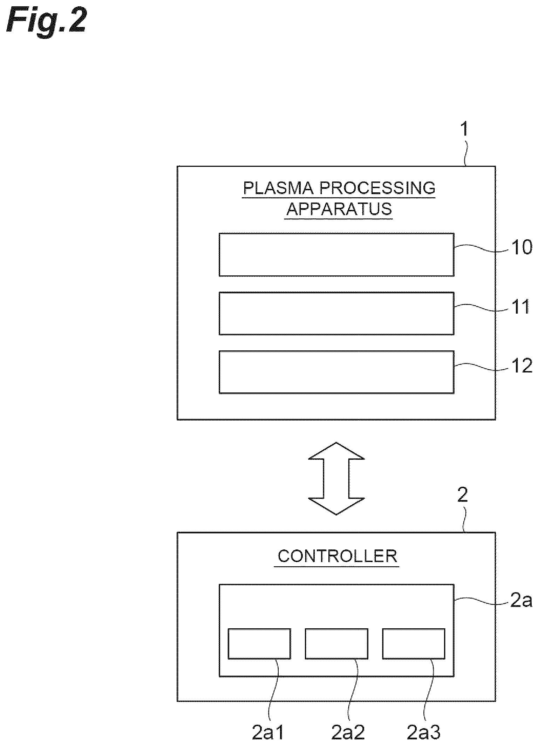

FIG. 2 is a diagram schematically showing a dry development apparatus according to another exemplary embodiment. In one embodiment, a plasma processing system includes a plasma processing apparatus 1 and a controller 2. The plasma processing system is an example of a dry development system, and the plasma processing apparatus 1 is an example of a dry development apparatus. The plasma processing apparatus 1 includes a plasma processing chamber (hereinafter, also simply referred to as a "processing chamber") 10, a substrate support 11, and a plasma generator 12. The plasma processing chamber 10 has a plasma processing space. In addition, the plasma processing chamber 10 has at least one gas supply port for supplying at least one processing gas into the plasma processing space and at least one gas exhaust port for exhausting gases from the plasma processing space. The gas supply port is connected to a gas supply 20 described below and the gas exhaust port is connected to an exhaust system 40 described below. The substrate support 11 is disposed in the plasma processing space and has a substrate supporting surface for supporting the substrate W.

The plasma generator 12 is configured to generate plasma from at least one processing gas supplied into the plasma processing space. The plasma formed in the plasma processing space may be a capacitively coupled plasma (CCP), an inductively coupled plasma (ICP), an electron-cyclotron-resonance (ECR) plasma, a helicon wave plasma (HWP), or a surface wave plasma (SWP), or the like. In addition, various types of plasma generators including an alternating current (AC) plasma generator and a direct current (DC) plasma generator may be used. In one embodiment, an AC signal (AC power) used in the AC plasma generator has a frequency in a range of 100 kHz to 10 GHz. Therefore, the AC signal includes a radio frequency (RF) signal and a microwave signal. In one embodiment, the RF signal has a frequency in a range of 100 kHz to 150 MHz.

The controller 2 processes computer-executable instructions for causing the plasma processing apparatus 1 to execute various steps described in the present disclosure. The controller 2 may be configured to control each element of the plasma processing apparatus 1 to execute various steps described herein. In one embodiment, the functions of the controller 2 may be partially or entirely incorporated into the plasma processing apparatus 1. The controller 2 is realized by, for example, a computer 2a. The controller 2 may include a processor 2a1, a storage 2a2, and a communication interface 2a3. Each configuration of the controller 2 may be the same as each configuration of the controller 200 described above (refer to FIG. 1).

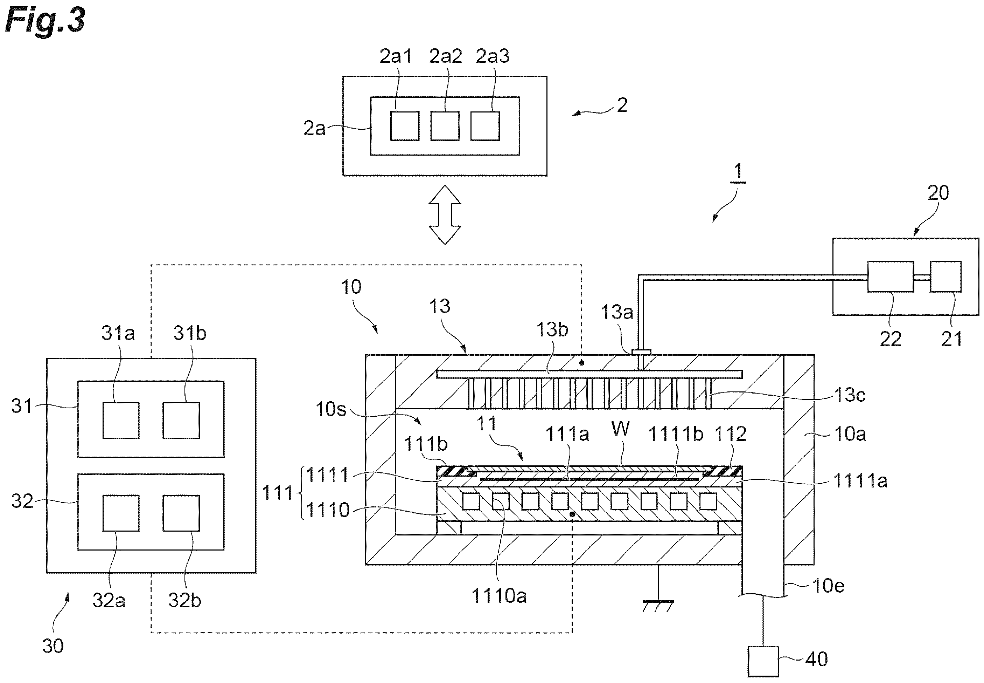

In the following, a configuration example of a capacitively coupled plasma processing apparatus, which is an example of the plasma processing apparatus 1, will be described. FIG. 3 is a diagram schematically showing a dry development apparatus according to another exemplary embodiment.

The capacitively coupled plasma processing apparatus 1 includes the plasma processing chamber 10, the gas supply 20, a power supply 30, and an exhaust system 40. In addition, the plasma processing apparatus 1 includes a substrate support 11 and a gas introduction unit. The gas introduction unit is configured to introduce at least one processing gas into the plasma processing chamber 10. The gas introduction unit includes a shower head 13. The substrate support 11 is disposed in the plasma processing chamber 10. The shower head 13 is disposed above the substrate support 11. In one embodiment, the shower head 13 constitutes at least a part of the ceiling of the plasma processing chamber 10. The plasma processing chamber 10 has a plasma processing space 10s that is defined by the shower head 13, a side wall 10a of the plasma processing chamber 10, and the substrate support 11. The plasma processing chamber 10 is grounded. The shower head 13 and the substrate support 11 are electrically insulated from a housing of the plasma processing chamber 10.

The substrate support 11 includes a body 111 and a ring assembly 112. The body 111 has a central region 111a for supporting the substrate W and an annular region 111b for supporting the ring assembly 112. A wafer is an example of the substrate W. The annular region 111b of the body 111 surrounds the central region 111a of the body 111 in a plan view. The substrate W is disposed on the central region 111a of the body 111, and the ring assembly 112 is disposed on the annular region 111b of the body 111 to surround the substrate W on the central region 111a of the body 111. Thus, the central region 111a is also referred to as a substrate supporting surface for supporting the substrate W, while the annular region 111b is also referred to as a ring supporting surface for supporting the ring assembly 112.

In one embodiment, the body 111 includes a base 1110 and an electrostatic chuck 1111. The base 1110 includes a conductive member. The conductive member of the base 1110 can function as a lower electrode. The electrostatic chuck 1111 is disposed on the base 1110. The electrostatic chuck 1111 includes a ceramic member 1111a and an electrostatic electrode 1111b disposed in the ceramic member 1111a. The ceramic member 1111a has the central region 111a. In one embodiment, the ceramic member 1111a also has the annular region 111b. In addition, other members surrounding the electrostatic chuck 1111, such as an annular electrostatic chuck or an annular insulating member, may have the annular region 111b. In this case, the ring assembly 112 may be disposed on the annular electrostatic chuck or the annular insulating member, or may be disposed on both the electrostatic chuck 1111 and the annular insulating member. In addition, at least one RF/DC electrode coupled to an RF power supply 31 and/or a DC power supply 32 described below may be disposed in the ceramic member 1111a. In this case, at least one RF/DC electrode functions as the lower electrode. In a case where a bias RF signal and/or a DC signal described below is supplied to at least one RF/DC electrode, the RF/DC electrode is also referred to as a bias electrode. The conductive member of the base 1110 and at least one RF/DC electrode may function as a plurality of lower electrodes. In addition, the electrostatic electrode 1111b may function as the lower electrode. Therefore, the substrate support 11 includes at least one lower electrode.

The ring assembly 112 includes one or a plurality of annular members. In one embodiment, the one or plurality of annular members include one or a plurality of edge rings and at least one cover ring. The edge ring is formed of a conductive material or an insulating material, and the cover ring is formed of an insulating material.

The substrate support 11 may include a temperature adjusting module that is configured to adjust at least one of the electrostatic chuck 1111, the ring assembly 112, and the substrate to a target temperature. The temperature adjusting module may include a heater, a heat transfer medium, a flow path 1110a, or any combination thereof. A heat transfer fluid, such as brine or gas, flows into the flow path 1110a. In one embodiment, the flow path 1110a is formed in the base 1110, and one or a plurality of heaters are disposed in the ceramic member 1111a of the electrostatic chuck 1111. In addition, the substrate support 11 may further include a heat transfer gas supply configured to supply a heat transfer gas to a gap between a back surface of the substrate W and the central region 111a.

The shower head 13 is configured to introduce at least one processing gas from the gas supply 20 into the plasma processing space 10s. The shower head 13 has at least one gas supply port 13a, at least one gas diffusion chamber 13b, and a plurality of gas introduction ports 13c. The processing gas supplied to the gas supply port 13a passes through the gas diffusion chamber 13b and is introduced into the plasma processing space 10s from the plurality of gas introduction ports 13c. In addition, the shower head 13 includes at least one upper electrode. The gas introduction unit may include one or a plurality of side gas injectors (SGI) attached to one or a plurality of openings formed in the side wall 10a, in addition to the shower head 13.

The gas supply 20 may include at least one gas source 21 and at least one flow rate control device 22. In one embodiment, the gas supply 20 is configured to supply at least one processing gas from the respective corresponding gas source 21 through the respective corresponding flow rate control device 22 to the shower head 13. Each flow rate control device 22 may include, for example, a mass flow controller or a pressure-controlled flow rate control device. Further, the gas supply 20 may include at least one flow rate modulation device that modulates or pulses the flow rate of the at least one processing gas.

The power supply 30 includes the RF power supply 31, which is coupled to the plasma processing chamber 10 via at least one impedance matching circuit. The RF power supply 31 is configured to supply at least one RF signal (RF power) to at least one lower electrode and/or at least one upper electrode. As a result, plasma is formed from at least one processing gas supplied to the plasma processing space 10s. Therefore, the RF power supply 31 can function as at least a part of the plasma generator 12. In addition, by supplying the bias RF signal to at least one lower electrode, a bias potential is generated on the substrate W, and ion components in the formed plasma can be drawn into the substrate W.

In one embodiment, the RF power supply 31 includes a first RF generator 31a and a second RF generator 31b. The first RF generator 31a is configured to be coupled to at least one lower electrode and/or at least one upper electrode via at least one impedance matching circuit, and is configured to generate a source RF signal (source RF power) for plasma generation. In one embodiment, the source RF signal has a frequency in a range of 10 MHz to 150 MHz. In one embodiment, the first RF generator 31a may be configured to generate a plurality of source RF signals having different frequencies. The generated one or plurality of source RF signals are supplied to at least one lower electrode and/or at least one upper electrode.

The second RF generator 31b is configured to be coupled to at least one lower electrode via at least one impedance matching circuit and is configured to generate a bias RF signal (bias RF power). The frequency of the bias RF signal may be the same as or different from the frequency of the source RF signal. In one embodiment, the bias RF signal has a frequency lower than the frequency of the source RF signal. In one embodiment, the bias RF signal has a frequency in a range of 100 kHz to 60 MHz. In one embodiment, the second RF generator 31b may be configured to generate a plurality of bias RF signals having different frequencies. The generated one or plurality of bias RF signals are supplied to at least one lower electrode. In addition, in various embodiments, at least one of the source RF signal and the bias RF signal may be pulsed.

The power supply 30 may include the DC power supply 32 coupled to the plasma processing chamber 10. The DC power supply 32 includes a first DC generator 32a and a second DC generator 32b. In one embodiment, the first DC generator 32a is configured to be connected to at least one lower electrode and is configured to generate a first DC signal. The generated first DC signal is applied to at least one lower electrode. In one embodiment, the second DC generator 32b is configured to be connected to at least one upper electrode and is configured to generate a second DC signal. The generated second DC signal is applied to at least one upper electrode.

In various embodiments, the first and second DC signals may be pulsed. In this case, a sequence of the voltage pulses is applied to at least one lower electrode and/or at least one upper electrode. The voltage pulse may have a pulse waveform of a rectangular, trapezoidal, triangular, or a combination thereof. In one embodiment, a waveform generator for generating the sequence of voltage pulses from the DC signal is connected between the first DC generator 32a and at least one lower electrode. Therefore, the first DC generator 32a and the waveform generator constitute a voltage pulse generator. In a case where the second DC generator 32b and the waveform generator constitute the voltage pulse generator, the voltage pulse generator is connected to at least one upper electrode. The voltage pulse may have a positive polarity or may have a negative polarity. Further, the sequence of the voltage pulses may include one or a plurality of positive-polarity voltage pulses and one or a plurality of negative-polarity voltage pulses in one cycle. The first and second DC generators 32a and 32b may be provided in addition to the RF power supply 31, or the first DC generator 32a may be provided instead of the second RF generator 31b.

The exhaust system 40 may be connected to, for example, a gas exhaust port 10e provided in a bottom of the plasma processing chamber 10. The exhaust system 40 may include a pressure regulating valve and a vacuum pump. The pressure in the plasma processing space 10s is adjusted by the pressure regulating valve. The vacuum pump may include a turbo molecular pump, a dry pump, or a combination thereof.

### [First Embodiment]

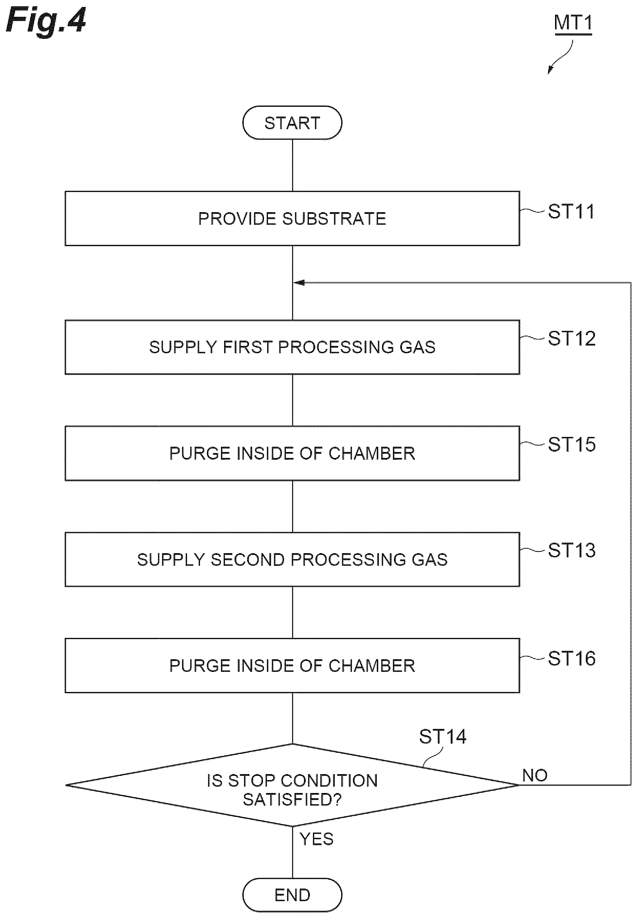

FIG. 4 is a flowchart of a dry development method (hereinafter, referred to as a "method MT1") according to one exemplary embodiment. As shown in FIG. 4, the method MT1 includes Step ST11 of providing a substrate W, Step ST12 of supplying a first processing gas, and Step ST13 of supplying a second processing gas. The method MT1 may include Step ST14 of determining whether or not a stop condition is satisfied after Step ST13. The method MT1 may include Step ST15 of purging an internal space of a chamber 102 between Step ST12 and Step ST13. The method MT1 may have Step ST16 of purging the internal space of the chamber 102 between Step ST13 and Step ST14. At least one of Step ST15 and Step ST16 may be performed. The method MT1 may not include Step ST15 and Step ST16.

The method MT1 may be performed by using any one of the systems for processing a substrate described above (refer to FIGS. 1 to 3), or may be performed by using two or more of these systems for processing a substrate. For example, the method MT1 may be performed by using the heat treatment system (refer to FIG. 1). In the following, a case where the controller 200 controls each unit of the heat treatment apparatus 100 to perform the method MT1 on the substrate W will be described as an example.

### (Step ST11: Provision of Substrate)

First, in Step ST11, the substrate W is provided in the processing chamber 102 of the heat treatment apparatus 100. The substrate W is provided on the substrate support 121, for example, by lowering the lift pin 123. After the substrate W is disposed on the substrate support 121, the temperature of the substrate support 121 is adjusted to a set temperature. The temperature of the substrate support 121 may be adjusted by controlling the output of one or more of the side wall heater 104, the stage heater 120, the ceiling heater 130, and the pipe heater 160. In the method MT1, the temperature of the substrate support 121 may be adjusted to the set temperature before Step ST11. That is, after the temperature of the substrate support 121 is adjusted to the set temperature, the substrate W may be provided on the substrate support 121.

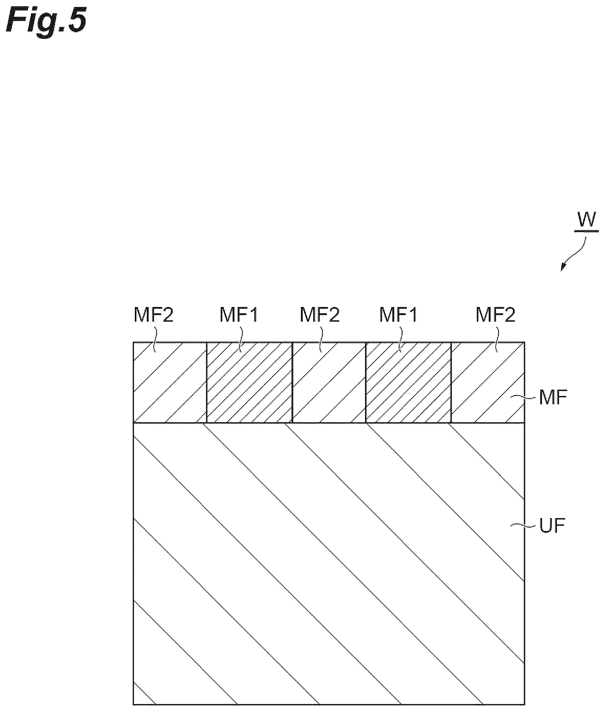

FIG. 5 is a cross-sectional view of an example of the substrate W to which the method MT1 may be applied. The substrate W includes the underlying film UF and the metal-containing resist MF formed on the underlying film UF. The substrate W may be used for manufacturing a semiconductor device. The semiconductor device includes, for example, a memory device such as a DRAM or a 3D-NAND flash memory, and a logic device.

The metal-containing resist MF may contain at least one selected from the group consisting of tin (Sn), hafnium (Hf), and titanium (Ti). The metal-containing resist MF may contain, for example, at least one selected from the group consisting of tin oxide, hafnium oxide, and titanium oxide, or may contain an organic substance.

The metal-containing resist MF may be an EUV resist. As shown in FIG. 5, the metal-containing resist MF has an exposed first region MF1 and an unexposed second region MF2. The first region MF1 may be an exposure region exposed to the EUV The second region MF2 may be an unexposed region that is not exposed to the EUV.

The underlying film UF may be formed on a silicon wafer. The underlying film UF may be a carbon-containing film, a dielectric film, a metal film, a semiconductor film, or a laminated film thereof.

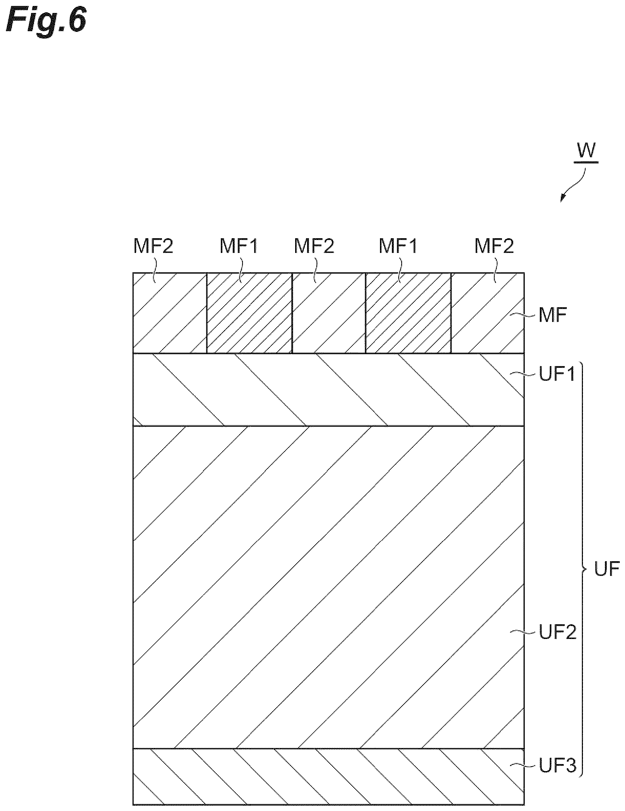

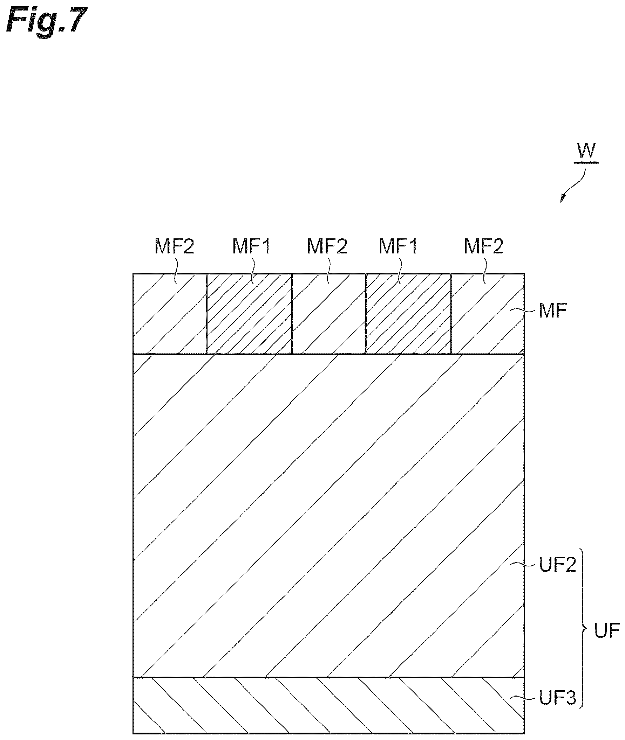

FIGS. 6 and 7 are cross-sectional views of another example of the substrate W to which the method MT1 may be applied. As shown in FIG. 6, the underlying film UF may be made of a first film UF1, a second film UF2, and a third film UF3. In addition, as shown in FIG. 7, the underlying film UF may be made of the second film UF2 and the third film UF3.

The first film UF1 is, for example, a spin-on-glass (SOG) film, a SiC film, a SiON film, a Si-containing anti-reflective coating (SiARC) film, or a carbon-containing film. The second film UF2 is, for example, a spin-on carbon (SOC) film, an amorphous carbon film, or a silicon-containing film. The third film UF3 is, for example, a silicon-containing film. The silicon-containing film is, for example, a silicon oxide film, a silicon nitride film, a silicon oxynitride film, a silicon carbon nitride film, a polycrystalline silicon film, or a carbon-containing silicon film. The third film UF3 may be made of a plurality of types of laminated silicon-containing films. For example, the third film UF3 may be made of a silicon oxide film and a silicon nitride film which are alternately laminated. The third film UF3 may be made of a silicon oxide film and a polycrystalline silicon film which are alternately laminated. The third film UF3 may be a laminated film including a silicon nitride film, a silicon oxide film, and a polycrystalline silicon film. The third film UF3 may be made of a laminated silicon oxide film and silicon carbon nitride film. The third film UF3 may be a laminated film including a silicon oxide film, a silicon nitride film, and a silicon carbon nitride film.

In one embodiment, the substrate W is formed as follows. First, a photoresist film containing a metal is formed on an underlying film which has been subjected to an adhesion processing or the like. The film formation may be performed by a dry process, may be performed by a wet process such as a solution coating method, or may be performed by both the dry process and the wet process. Before forming the photoresist film, surface reforming processing of the underlying film may be performed. The wafer after the film formation is subjected to a heating treatment, that is, prebake (PAB: Post Apply Bake). An additional heating treatment may be performed after the pre bake. The wafer after the heating treatment is transported to an exposure device, and the photoresist film is irradiated with EUV via an exposure mask (reticle). As a result, the substrate W including the underlying film UF and the metal-containing resist MF having the exposed first region MF1 and the unexposed second region MF2 is formed. The first region MF1 is a region corresponding to an opening provided in the exposure mask (reticle). The second region MF2 is a region corresponding to a pattern provided on the exposure mask (reticle). The EUV has, for example, a wavelength in the range of 10 nm to 20 nm. The EUV may have a wavelength in the range of 11 nm to 14 nm, and has a wavelength of 13.5 nm in one example. The wafer after the exposure is transported from the exposure device to the heat treatment apparatus under atmosphere control, and is subjected to a heating treatment, that is, a post exposure bake (PEB). The wafer after the exposure may be further subjected to heating treatment after PEB.

### (Step ST12: Supply of First Processing Gas)

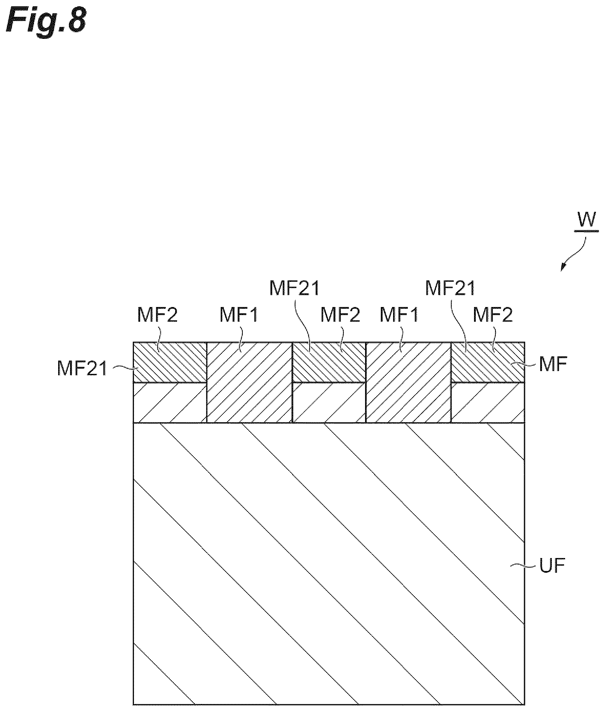

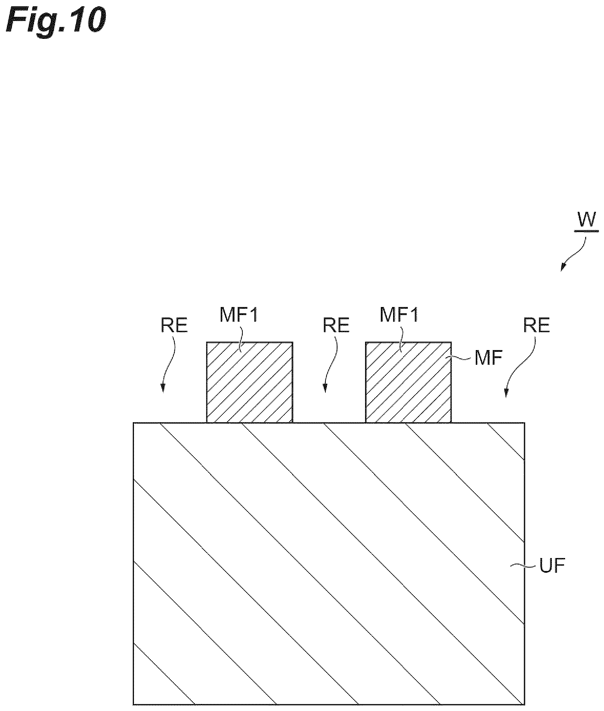

In the following description, the processing will be described as being performed on the substrate W shown in FIG. 5. FIGS. 8 to 10 are cross-sectional views showing a step of the dry development method according to one exemplary embodiment. FIG. 8 is a cross-sectional view of the substrate W in Step ST12. In Step ST12, a first processing gas including a fluorine-containing gas is supplied into the processing chamber 10, thereby forming a metal fluoride layer MF21 on a surface of the second region MF2 as shown in FIG. 8. In Step ST12, the fluorine contained in the fluorine-containing gas is reacted with the metal (for example, tin) present on the surface of the second region MF2 to form the metal fluoride layer MF21 (for example, a tin fluoride (SnF) layer). In the example of FIG. 8, the metal fluoride layer MF21 may be generated without generating plasma. At the end of Step ST12, the supply of the first processing gas may be stopped.

The fluorine-containing gas may include at least one selected from the group consisting of a hydrogen fluoride gas (HF gas) and a xenon fluoride gas (for example, XeF₂ gas). The first processing gas may include an inert gas. The inert gas may include a noble gas. The inert gas may include at least one selected from the group consisting of nitrogen gas (N₂ gas), argon gas (Ar gas), xenon gas (Xe gas), and krypton gas (Kr gas).

In Step ST12, the partial pressure of the fluorine-containing gas to be supplied into the processing chamber 10 can be controlled. The partial pressure of the fluorine-containing gas may be 13.3 Pa or more. The partial pressure of the fluorine-containing gas may be 13.3 kPa or less. The partial pressure of the fluorine-containing gas may be 13.3 Pa or more and 13.3 kPa or less. The partial pressure of the fluorine-containing gas may be 0.1 Torr or more. The partial pressure of the fluorine-containing gas may be 100 Torr or less. The partial pressure of the fluorine-containing gas may be 0.1 Torr or more and 100 Torr or less.

In Step ST12, the substrate support 121 may be heated. Step ST12 can be performed in a state in which a temperature of the substrate support 121 is set to a first temperature. The first temperature may be 0°C or higher. The first temperature may be 30°C or higher. The first temperature may be 100°C or higher. The first temperature may be 300°C or lower. The first temperature may be 30°C or higher and 300°C or lower.

### (Step ST15: Purging)

After Step ST12, in Step ST15, a step of purging an internal space of the chamber 102 may be performed. In Step ST15, for example, the inert gas may be supplied into the chamber 102, and the gas or the like in the chamber 102 may be discharged. The inert gas may include at least one selected from the group consisting of nitrogen gas and argon gas.

### (Step ST13: Supply of Second Processing Gas)

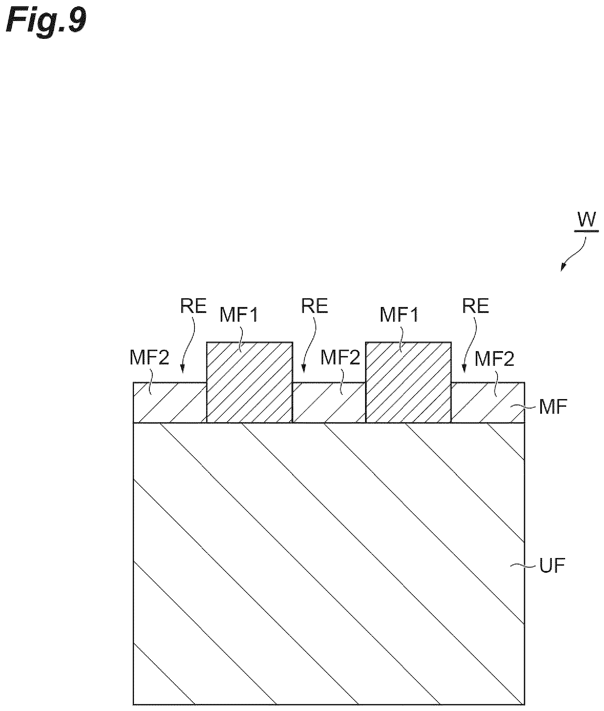

FIG. 9 is a cross-sectional view of the substrate W in Step ST13. After Step ST12, in Step ST13, the second processing gas including a chlorine-containing gas is supplied into the processing chamber 10 to remove the metal fluoride layer MF21 as shown in FIG. 9. In Step ST13, the metal fluoride layer MF21 can be selectively removed from the first region MF1 by the reaction between the chlorine-containing gas and the metal fluoride layer MF21. In Step ST13, a volatile metal chloride can be generated by an exchange reaction between chlorine in the chlorine-containing gas and fluorine in the metal fluoride layer MF21. By performing Step ST13, a recess RE can be formed on the substrate W as shown in FIG. 9. At the end of Step ST13, the supply of the second processing gas may be stopped.

The chlorine-containing gas may include at least one selected from the group consisting of a silicon tetrachloride gas (SiCl₄ gas), a titanium tetrachloride gas (TiCl₄ gas), a dimethylaluminum chloride gas (DMAC gas), a thionyl chloride gas (SOCl₂ gas), and an acetyl chloride gas (CH₃COCl gas). The second processing gas may include an inert gas. The inert gas may include a noble gas. The inert gas may include at least one selected from the group consisting of nitrogen gas (N₂ gas), argon gas (Ar gas), xenon gas (Xe gas), and krypton gas (Kr gas) gas.

The pressure in the processing chamber 10 in Step ST13 may be lower than the pressure in the processing chamber in Step ST12. In Step ST13, the partial pressure of the chlorine-containing gas to be supplied into the processing chamber 10 can be controlled. The partial pressure of the chlorine-containing gas may be 13.3 Pa or more. The partial pressure of the chlorine-containing gas may be 13.3 kPa or less. The partial pressure of the chlorine-containing gas may be 13.3 Pa or more and 13.3 kPa or less. The partial pressure of the chlorine-containing gas may be 0.1 Torr or more. The partial pressure of the fluorine-containing gas may be 100 Torr or less. The partial pressure of the chlorine-containing gas may be 0.1 Torr or more and 100 Torr or less.

In Step ST13, the substrate support 121 may be heated. Step ST13 can be performed in a state in which a temperature of the substrate support 121 is set to a second temperature. The second temperature may be the same as the first temperature or may be higher than the first temperature. The second temperature may be 30°C or higher or may be 100°C or higher. The second temperature may be 300°C or lower or may be 200°C or lower. The second temperature may be 30°C or higher and 300°C or lower.

### (Step ST16: Purging)

After Step ST13, in Step ST16, a step of purging an internal space of the chamber 102 may be performed. In Step ST16, for example, the inert gas may be supplied into the chamber 102, and the gas or the like in the chamber 102 may be discharged. The inert gas may include at least one selected from the group consisting of nitrogen gas and argon gas.

Step ST12 and Step ST13 may be repeated in this order. That is, the method MT1 may include a step (corresponding to Step ST14) of repeating Step ST12 and Step ST13. In the step of repeating Step ST12 and Step ST13, at least one of Step ST15 and Step ST16 may be repeated. The step of repeating Step ST12 and Step ST13 may be repeated a predetermined number of times. The step of repeating Step ST12 and Step ST13 may be repeated until the recess RE reaches the underlying film UF (until the underlying film UF is exposed). The step of performing Step ST12 and Step ST13 once each may be regarded as one cycle. In this case, a thickness of the second region MF2 removed per cycle in a direction from the metal-containing resist MF to the underlying film UF may be 5 nm or more and 20 nm or less.

The step of repeating Step ST12 and Step ST13 may include changing at least one selected from the group consisting of the pressure in the chamber 102, the temperature of the substrate support 121, the processing time of Step ST12, and the processing time of Step ST13 according to an aspect ratio of the recess RE formed in Step ST13. For example, the step of repeating Step ST12 and Step ST13 may include executing at least one of reducing the pressure in the chamber 102, reducing the temperature of the substrate support 121, shortening the processing time of Step ST12, or shortening the processing time of Step ST13, according to an increase in the aspect ratio of the recess RE formed in Step ST13.

In the method MT1, each time Step ST12 and Step ST13 are repeated, the pressure in the chamber 102, the temperature of the substrate support 121, the processing time of Step ST12, and the processing time of Step ST13 (hereinafter, may be referred to as each parameter) may be adjusted according to the aspect ratio of the recess RE. Each parameter may be adjusted based on an absolute value of the aspect ratio or may be adjusted based on an amount of increase of the aspect ratio. For example, in the method MT1, each time Step ST12 and Step ST13 are repeated, each parameter may be decreased by several percent to several tens of percent in accordance with an increase in the aspect ratio of the recess RE. A limit on the number of times each parameter can be adjusted may be set.

For example, a table showing a relationship between the aspect ratio of the recess RE and each parameter may be stored in the storage 200a2 of the controller 200. The controller 200 may adjust each parameter based on the table stored in the storage 200a2.

### (Step ST14: Determination)

The method MT1 may include Step ST14 of determining whether or not a stop condition is satisfied. The stop condition may be satisfied in a case where the removal amount (depth of the recess RE) of the second region MF2 reaches a threshold value. The stop condition may be satisfied in a case where the underlying film UF is exposed. The stop condition may be satisfied in a case where the total processing time of Step ST12 and Step ST13 reaches a threshold value. The stop condition may be satisfied in a case where the number of repetitions of Step ST12 and Step ST13 reaches a threshold value. In a case where the stop condition is not satisfied in Step ST14 (Step ST14: NO), Step ST12 and Step ST13 may be repeated again. In that case, in the method MT1, the next cycle may be performed by changing the processing conditions from the previous cycle. In the method MT1, for example, the partial pressure of the fluorine-containing gas and the partial pressure of the chlorine-containing gas may be changed. In the method MT1, for example, the temperature of the substrate support 121 may be changed, or the type of noble gas may be changed. In the method MT1, the change contents described above may be appropriately combined. On the other hand, in a case where the stop condition is satisfied in Step ST14 (Step ST14: YES), the method MT1 may end.

According to the method MT1, the second region MF2 can be selectively removed from the first region MF1. Therefore, the metal-containing resist can be appropriately developed. Specifically, in the method MT1, the first region MF1 is removed at a first speed, whereas the second region MF2 can be removed at a second speed higher than the first speed. The first speed is, for example, 1 nm/cycle or less. The second speed is, for example, 2 nm/cycle or more and 10 nm/cycle or less. Therefore, the second region MF2 can be removed at a high selectivity ratio (a ratio of the removal rate of the second region MF2 to the removal rate of the first region MF1) with respect to the first region MF1.

The mechanism capable of selectively removing the second region MF2 with respect to the first region MF1 is presumed as follows, but is not limited to this. The first region MF1 and the second region MF2 both include, for example, a bond (Sn-O bond) between tin and oxygen. In a case where the first region MF1 and the second region MF2 are exposed to the fluorine-containing gas, the Sn-O bond is replaced with a Sn-F bond. The first region MF1 includes a larger number of Sn-O bonds than the second region MF2. In other words, in the first region MF1, the density of the Sn-O bonds per unit volume is relatively high. Therefore, the replacement with the Sn-F bond by the fluorine-containing gas is more likely to occur at a deeper position in the second region MF2 than in the first region MF1. Further, the number of organic ligands included in the second region MF2 is larger than the number of organic ligands included in the first region MF1. Accordingly, the second region MF2 is more likely to volatilize than the first region MF1.

Further, in the method MT1, the thickness of the metal fluoride layer MF21 formed in Step ST12 becomes saturated at a certain point. Therefore, a depth of the recess RE (the removal amount of the second region MF2) formed in Step ST13 can be controlled. For this reason, according to the method MT1, high in-plane uniformity is obtained for the depth of the recess RE. That is, a difference between a depth of the recess RE at the center of the substrate W and a depth of the recess RE at the peripheral edge of the substrate W can be reduced.

In a case where the plasma is not generated in Step ST12, damage to the substrate W or the substrate support 121 can be suppressed as compared with a case where the plasma is used.

In a case where the first temperature of the substrate support 121 is 30°C or higher in Step ST12, a reaction between the second region MF2 and the fluorine-containing gas is promoted.

The second temperature of the substrate support 121 in Step ST13 may be higher than the first temperature of the substrate support 121 in Step ST12. In this case, since the reaction between the metal fluoride layer MF21 and the chlorine-containing gas is promoted, the removal of the metal fluoride layer MF21 is also promoted. For example, in a case where the metal fluoride layer MF21 is an SnF layer, F of SnF can be exchanged with Cl by a reaction between the chlorine-containing gas and SnF. As a result, SnCl having high volatility may be generated. By setting a temperature of the substrate support 121 to the second temperature, the reaction between the chlorine-containing gas and SnF and the volatilization of SnCl are promoted.

In a case where the method MT1 includes the step of repeating Step ST12 and Step ST13, a thickness of the second region MF2 removed in a direction from the metal-containing resist MF to the underlying film UF can be increased.

The step of repeating Step ST12 and Step ST13 may include executing at least one of reducing the pressure in the chamber 102, reducing the temperature of the substrate support 121, shortening the processing time of Step ST12, or shortening the processing time of Step ST13, according to an increase in the aspect ratio of the recess RE formed in Step ST13. The recesses RE of the metal-containing resist MF tend to have an inverse tapered shape that becomes wider toward the bottom (toward the underlying film UF). On the other hand, for example, progress of the dry development is suppressed by decreasing the pressure in the chamber 102 in accordance with an increase in the aspect ratio of the recess RE. As a result, a side wall of the recess RE is less likely to be scraped, and thus a shape of the side wall of the recess RE after development can be made closer to vertical.

### [Second Embodiment]

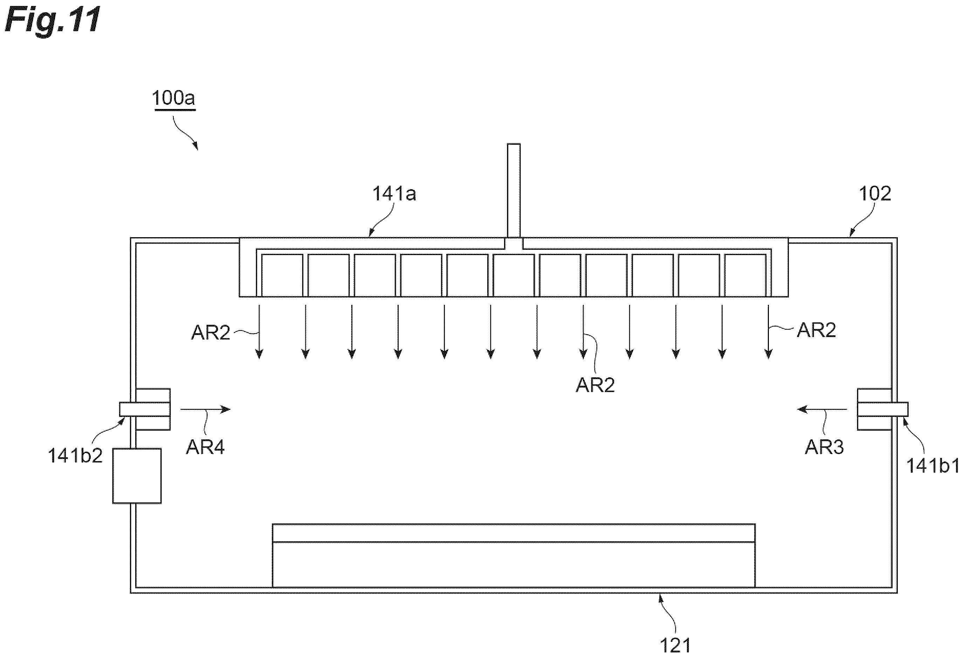

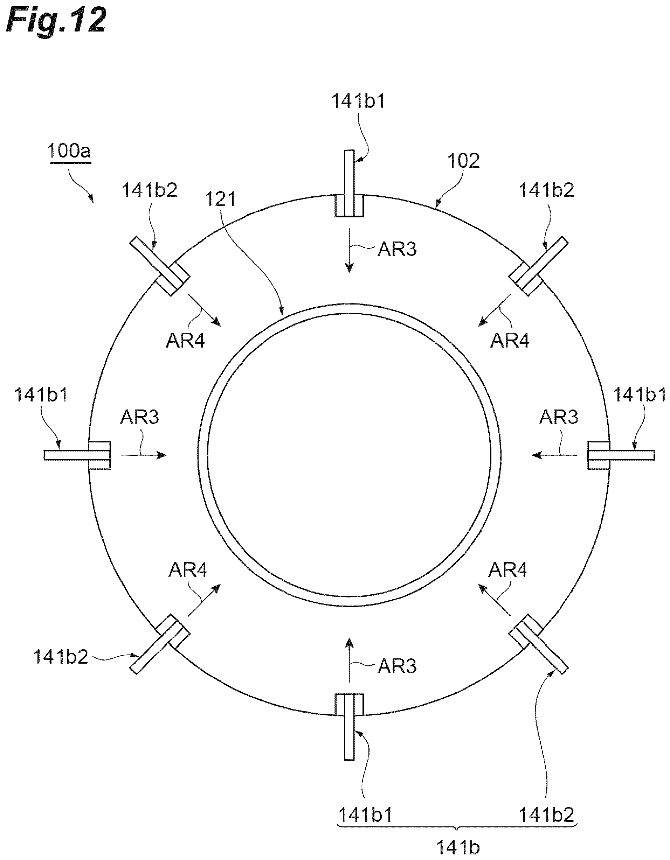

As the heat treatment system, a heat treatment apparatus 100a shown in FIGS. 11 and 12 may be used instead of the heat treatment apparatus 100 shown in FIG. 1. FIGS. 11 and 12 are diagrams schematically showing a dry development apparatus according to another exemplary embodiment. FIG. 11 is a schematic cross-sectional view showing a configuration example of the heat treatment apparatus 100a. FIG. 12 is a schematic plan view showing a configuration example of the heat treatment apparatus 100a. The heat treatment apparatus 100a includes a shower head 141a provided on a ceiling of the processing chamber 102, and a plurality of gas nozzles 141b provided on a side wall of the processing chamber 102. The shower head 141a may be disposed to face the substrate support 121. The plurality of gas nozzles 141b may be disposed, for example, at equal intervals along a circumferential direction on the side wall of the processing chamber 102. The plurality of gas nozzles 141b may include a first gas nozzle 141b1 and a second gas nozzle 141b2. The first gas nozzle 141b1 and the second gas nozzle 141b2 may be alternately disposed. The types of gases supplied into the processing chamber 102 from the shower head 141a, the gas nozzle 141b1, and the gas nozzle 141b2 may be the same as or different from each other. The gas from the shower head 141a is supplied into the processing chamber 102 in a direction of an arrow AR2 shown in FIG. 11. The gas from the gas nozzle 141b1 is supplied into the processing chamber 102 in a direction of an arrow AR3 shown in FIGS. 11 and 12. The gas from the gas nozzle 141b2 is supplied into the processing chamber 102 in a direction of an arrow AR4 shown in FIGS. 11 and 12. The flow rates of the gases supplied into the processing chamber 102 from the shower head 141a, the gas nozzle 141b1, and the gas nozzle 141b2 may be the same as or different from each other. A heater may be disposed on the substrate support 121 and the side wall of the processing chamber 102. A gas exhaust port may be disposed on a bottom surface of the processing chamber 102.

According to the heat treatment apparatus 100a, the gas density in the processing chamber 102 can be easily controlled, and the in-plane uniformity in the development of the metal-containing resist MF can be improved.

### [Third Embodiment]

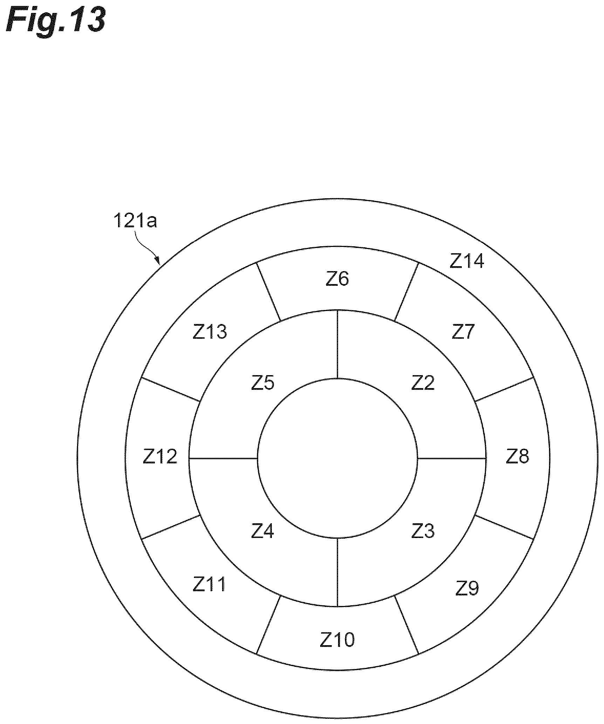

As the substrate support, a substrate support 121a shown in FIG. 13 may be used instead of the substrate support 121 shown in FIG. 1. FIG. 13 is a diagram schematically showing the substrate support 121a according to another exemplary embodiment. The substrate support 121a shown in FIG. 13 has a plurality of zones, and each zone is provided with a heater electrode. In the example shown in FIG. 13, the substrate support 121a has zones Z1 to Z14. The heater electrodes of each of zones Z1 to Z14 are configured such that power can be supplied independently to each of heater electrodes. That is, the substrate support 121a is configured to be able to independently control the temperature for each zone. For this reason, according to the substrate support 121a, the in-plane uniformity in the development of the metal-containing resist MF can be improved.

### [Fourth Embodiment]

The method MT1 may be performed by the plasma processing apparatus 1 shown in FIGS. 2 and 3 instead of the heat treatment apparatus 100a. In this case, in Step ST12, the metal fluoride layer MF21 may be generated by using plasma generated from the first processing gas including the fluorine-containing gas. By generating plasma from the first processing gas containing the fluorine-containing gas, active species such as fluorine ions and fluorine radicals can be generated. In the fourth embodiment, the fluorine-containing gas may include at least one selected from the group consisting of a hydrogen fluoride gas (HF gas), a xenon fluoride gas, a fluorocarbon gas, a hydrofluorocarbon gas, a nitrogen fluoride gas, and a sulfur fluoride gas. The fluorocarbon gas may include at least one selected from the group consisting of a C₄F₆ gas, a C₄F₈ gas, a C₃F₈ gas, and a CF₄ gas. The hydrofluorocarbon gas may include at least one selected from the group consisting of a CHF₃ gas and a CH₂F₂ gas. The nitrogen fluoride gas may include an NF₃ gas. The sulfur fluoride gas may include an SF₆ gas.

### [Fifth Embodiment]

In the dry development method according to the fifth embodiment, a precoat may be performed on the side wall of the processing chamber 102 or the parts (hereinafter, also referred to as "in-chamber parts") in the processing chamber 102, such as the substrate support 121, before the start of development. The precoat may be performed by an atomic layer deposition method (hereinafter, also referred to as an "ALD method"), a chemical vapor deposition method (hereinafter, also referred to as a "CVD method"), or the like. As the gas for forming the precoat, a gas capable of forming a film having resistance to the processing gas containing a carboxylic acid may be selected. For example, a silicon-containing gas may be used as the gas for forming the precoat. The silicon-containing gas may contain at least one selected from the group consisting of aminosilane and SiCl₄. In this case, a silicon oxide film can be formed as a precoat on the side wall of the processing chamber 102 or the in-chamber parts. Accordingly, it is possible to suppress the corrosion of the side wall of the processing chamber 102 or the in-chamber parts due to the processing gas.

In the dry development method according to the fifth embodiment, instead of the precoat or together with the precoat, the side wall of the processing chamber 102 and the in-chamber parts may be made of a material having resistance to a processing gas containing carboxylic acid or the like.

In the dry development method according to the fifth embodiment, the inside of the processing chamber 102 may be cleaned after the development. In this case, a cleaning gas may be supplied into the processing chamber 102 after heating the processing chamber 102 and the in-chamber parts. As the cleaning gas, a gas containing a hydrogen halide may be used. The gas containing a hydrogen halide may contain at least one selected from the group consisting of a hydrogen bromide gas (HBr gas) and a hydrogen fluoride gas. The cleaning may be performed by a thermal atomic layer etching method (hereinafter, also referred to as a "thermal ALE method"). Accordingly, it is possible to remove the metal oxide attached to the side wall of the processing chamber 102 and the in-chamber parts during development.

### [Sixth Embodiment]

In the dry development method according to the sixth embodiment, the underlying film UF may be etched using the metal-containing resist MF developed by the method MT1 as a mask. The etching conditions for the underlying film UF may be selected based on the film type of the underlying film UF or the like. The etching of the underlying film UF may be performed by the plasma processing apparatus 1 shown in FIG. 3.

### [Seventh Embodiment]

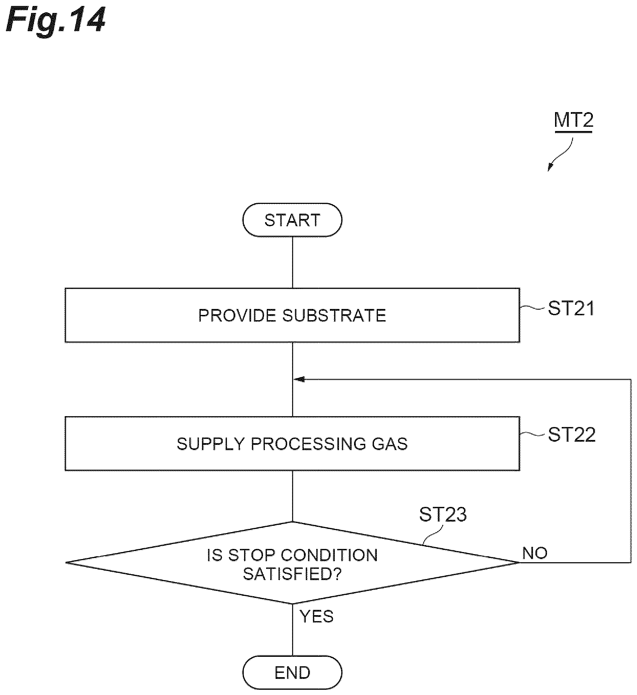

FIG. 14 is a flowchart of a dry development method (hereinafter, referred to as a "method MT2") according to another exemplary embodiment. The method MT2 includes Step ST21 of providing the substrate W and Step ST22 of supplying a processing gas. The method MT2 may have Step ST23 of determining whether or not a stop condition is satisfied after Step ST22. The substrate W may be the same as the substrate W of the first embodiment. The metal-containing resist MF is developed by using the method MT2.

In the method MT2, in Step ST22, the second region MF2 is removed by supplying a processing gas including a fluorine-containing gas and a chlorine-containing gas into the processing chamber 102. In Step ST22, a mixed gas including a fluorine-containing gas and a chlorine-containing gas can be supplied as the processing gas. That is, in Step ST22, the fluorine-containing gas and the chlorine-containing gas can be supplied at the same time. In this case, a step of forming the metal fluoride layer MF21 on the surface of the second region MF2 with the fluorine-containing gas and a step of removing the metal fluoride layer MF21 with the chlorine-containing gas can be performed at the same time. The types of gases contained in the fluorine-containing gas and the chlorine-containing gas may be the same as those in the method MT1.

In the method MT2, a ratio (F2/F1) of a flow rate F2 of the chlorine-containing gas to a flow rate F1 of the fluorine-containing gas may be adjusted as appropriate. F2/F1 may be changed during the execution of Step ST22. In one embodiment, F2/F1 may be changed as appropriate according to the processing time in Step ST22 or according to the aspect ratio of the recess RE formed in Step ST22. For example, as the aspect ratio of the recess RE increases, the flow rate of the fluorine-containing gas and the flow rate of the chlorine-containing gas may be adjusted such that F2/F1 increases, or the flow rate of the fluorine-containing gas and the flow rate of the chlorine-containing gas may be adjusted such that F2/F1 decreases.

Step ST22 may include reducing the pressure in the chamber 102 in accordance with an increase in the aspect ratio of the recess RE. Step ST22 may include changing at least one selected from the group consisting of the pressure in the chamber 102, the temperature of the substrate support 121, the processing time of Step ST12, and the processing time of Step ST13 according to an aspect ratio of the recess RE. For example, Step ST22 may include executing at least one of reducing the pressure in the chamber 102, reducing the temperature of the substrate support 121, shortening the processing time of Step ST12, or shortening the processing time of Step ST13, according to an increase in the aspect ratio of the recess RE.

Each parameter may be adjusted based on an absolute value of the aspect ratio or may be adjusted based on an amount of increase of the aspect ratio. For example, in Step ST22, the pressure in the chamber 102 may be decreased in accordance with an increase in the aspect ratio of the recess RE.

In the method MT2, the flow rate of the fluorine-containing gas and the flow rate of the chlorine-containing gas may be adjusted such that F2/F1 periodically fluctuates. Step ST22 may include a first period and a second period following the first period. In this case, F2/F1 in the first period may be larger than or smaller than F2/F1 in the second period.

In Step ST22, the temperature of the substrate support 121 can be controlled. An example of the temperature of the substrate support 121 in Step ST22 may be the same as the example of the temperature of the substrate support 121 in Step ST12 or Step ST13 of the method MT1.

The method MT2 may include Step ST23 of determining whether or not the stop condition is satisfied. Step ST23 may be performed in the same manner as Step ST14 of the method MT1. The stop condition may be satisfied in a case where the removal amount (depth of the recess RE) of the second region MF2 reaches a threshold value. The stop condition may be satisfied in a case where the underlying film UF is exposed. The stop condition may be satisfied in a case where the processing time of Step ST22 reaches a threshold value. In a case where the stop condition is not satisfied in Step ST23 (Step ST23: NO), Step ST22 may be repeated. In that case, in the method MT2, the processing condition may be changed from the previous Step ST22 to perform the next Step ST22. In the method MT2, for example, the partial pressure of the fluorine-containing gas and the partial pressure of the chlorine-containing gas may be changed. In the method MT2, for example, the temperature of the substrate support 121 may be changed, or the type of noble gas may be changed. In the method MT2, the change contents described above may be appropriately combined. On the other hand, in a case where the stop condition is satisfied in Step ST23 (Step ST23: YES), the method MT2 may end.

### [Eighth Embodiment]

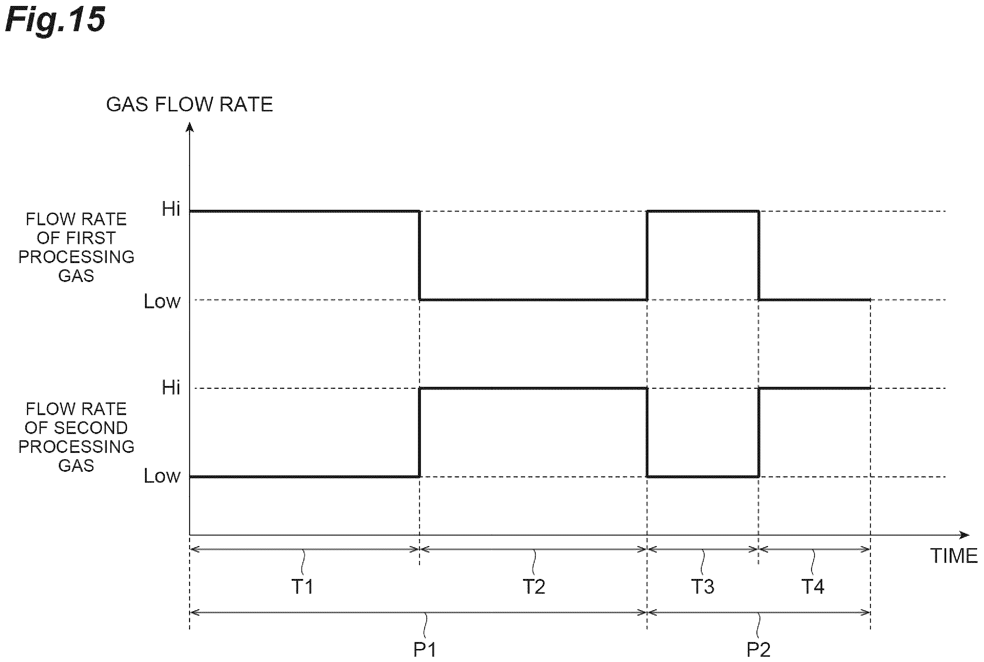

FIG. 15 is a diagram showing an example of control of a flow rate of the first processing gas and a flow rate of the second processing gas in the method MT1. The step of repeating Step ST12 and Step ST13 of the method MT1 may include a first period P1 in which Step ST12 is executed in a first processing time T1 and Step ST13 is executed in a second processing time T2. The step of repeating Step ST12 and Step ST13 may include a second period P2 after the first period P1. In the second period P2, Step ST12 is executed in a third processing time T3 shorter than the first processing time T1, and Step ST13 is executed in a fourth processing time T4 shorter than the second processing time T2.

In the example of FIG. 15, in the first processing time T1, the flow rate of the first processing gas is adjusted to a Hi level, while the flow rate of the second processing gas is adjusted to a Low level. As a result, in the first processing time T1, Step ST12 is progressed. The flow rate at the Hi level may be larger than the flow rate at the Low level. The flow rate at the Low level may be 50% or less of the flow rate at the Hi level or may be 20% or less. The flow rate at the Low level may be zero. In the second processing time T2, the flow rate of the first processing gas is adjusted to the Low level, while the flow rate of the second processing gas is adjusted to the Hi level. As a result, in the second processing time T2, Step ST13 is progressed. In the third processing time T3, the flow rate of the first processing gas is adjusted to the Hi level, while the flow rate of the second processing gas is adjusted to the Low level. As a result, in the third processing time T3, Step ST12 is progressed. In the fourth processing time T4, the flow rate of the first processing gas is adjusted to the Low level, while the flow rate of the second processing gas is adjusted to the Hi level. As a result, in the fourth processing time T4, Step ST13 is progressed.

The length of the third processing time T3 may be 80% or less, 50% or less, or 20% or less of the length of the first processing time T1. The length of the fourth processing time T4 may be 80% or less, 50% or less, or 20% or less of the length of the second processing time T2.

In the method according to the eighth embodiment, the progress of the dry development is suppressed in accordance with an increase in the aspect ratio of the recess RE. As a result, a side wall of the recess RE is less likely to be scraped, and thus a shape of the side wall of the recess RE after development can be made closer to vertical. In addition, in a case where the second period P2 is performed at the end period of the dry development (in a case where the bottom of the recess RE reaches the underlying film UF in the second period P2), a removal selectivity ratio of the second region MF2 with respect to the underlying film UF can be improved.

### [Ninth Embodiment]

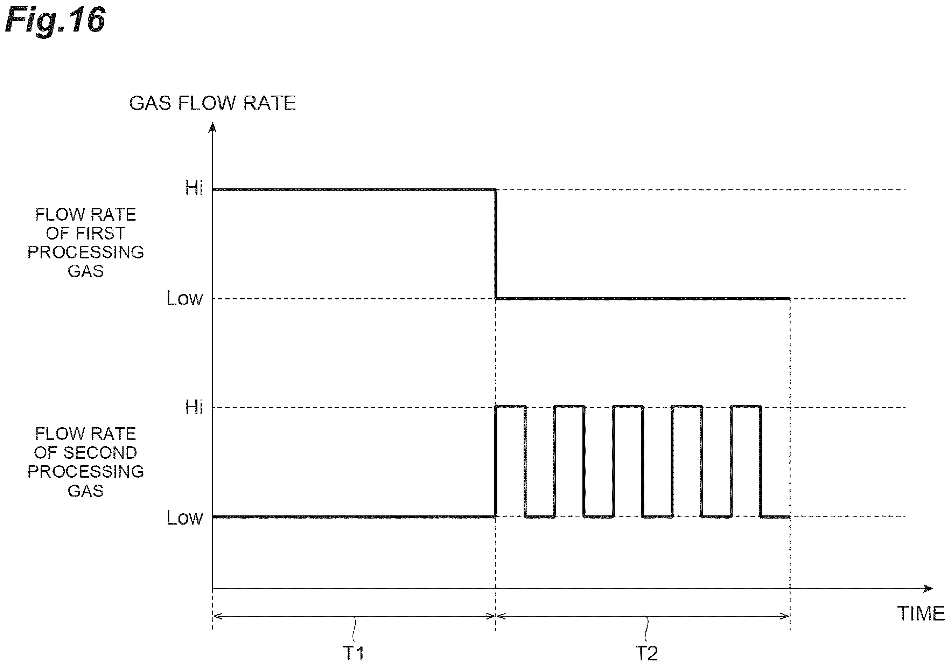

FIG. 16 is a diagram showing another example of the control of the flow rate of the first processing gas and the flow rate of the second processing gas in the method MT1. In the step of repeating Step ST12 and Step ST13 of the method MT1, one of the first processing gas and the second processing gas may be continuously supplied into the chamber 102. The other of the first processing gas and the second processing gas may be supplied into the chamber 102 such that a flow rate (first gas flow rate) at the Hi level and a flow rate (second gas flow rate) at the Low level that is smaller than the flow rate at the Hi level alternate. For example, the other of the first processing gas and the second processing gas may be intermittently supplied into the chamber 102. Alternatively, both the first processing gas and the second processing gas may be supplied into the chamber 102 such that the flow rate at the Hi level and the flow rate at the Low level alternate.

In the example of FIG. 16, in the first processing time T1, Step ST12 is progressed, and in the second processing time T2 after the first processing time T1, Step ST13 is progressed. The flow rate at the Low level may be 50% or less of the flow rate at the Hi level or may be 20% or less. The flow rate at the Low level may be zero.

In the example of FIG. 16, in the first processing time T1, the first processing gas is continuously supplied into the chamber 102 at the Hi level. In the second processing time T2, the second processing gas is supplied into the chamber 102 such that a flow rate at the Hi level and the flow rate at the Low level alternate. The present disclosure is not limited to this case, and in the first processing time T 1, the first processing gas may be supplied into the chamber 102 such that the flow rate of the first processing gas alternates between the Hi level and the Low level. In the second processing time T2, the second processing gas may be continuously supplied into the chamber 102 at the Hi level.

At least one of the first processing gas or the second processing gas may be subjected to pulse control by the controller 200 such that a flow rate at the Hi level and a flow rate at the Low level are alternately supplied. A duty ratio of the pulse of the pulse control may be 50%. Alternatively, the duty ratio of the pulse of the pulse control may be 20% or more, or 70% or more.

In the method according to the ninth embodiment, the amount of gas used can be reduced as compared with a case where both the first processing gas and the second processing gas are continuously supplied.

### [Tenth Embodiment]

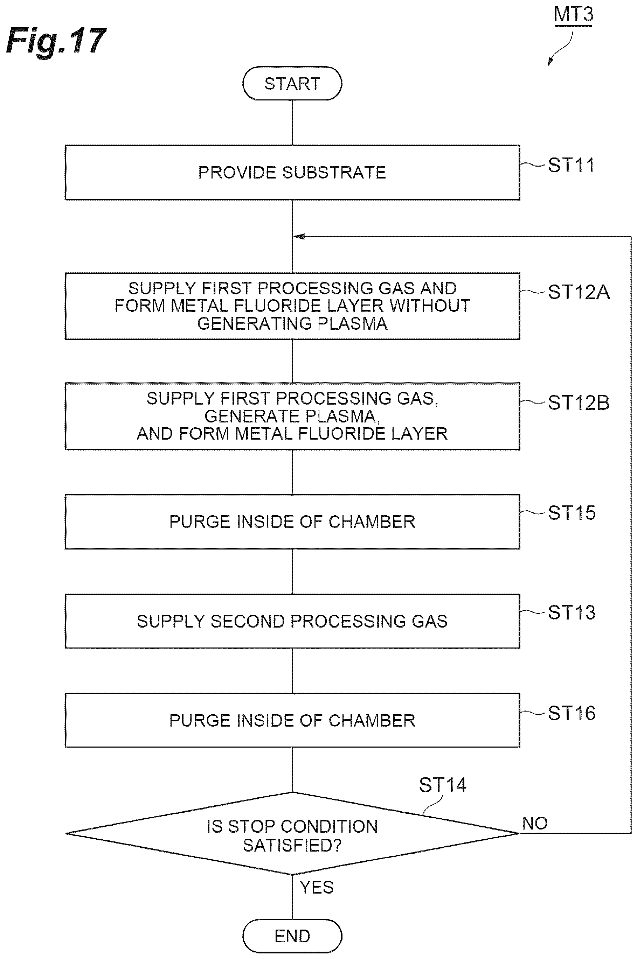

FIG. 17 is a flowchart of a dry development method (hereinafter, referred to as a "method MT3") according to another exemplary embodiment. The method MT3 may be performed by the plasma processing apparatus 1 of FIG. 2 or FIG. 3. The method MT3 may have Step ST12A and Step ST12B instead of Step ST12 in the method MT1. Step ST12B may be performed after Step ST12A or may be performed before Step ST12A. In Step ST12A, the metal fluoride layer MF21 may be formed on the surface of the second region MF2 by supplying the first processing gas containing a fluorine-containing gas into the processing chamber 10 without generating plasma (refer to FIG. 8). In Step ST12B, the metal fluoride layer MF21 may be generated by using plasma generated from the first processing gas including a fluorine-containing gas. By generating plasma from the first processing gas containing the fluorine-containing gas, active species such as fluorine ions and fluorine radicals can be generated.

### [Configuration Example of System for Processing Substrate]

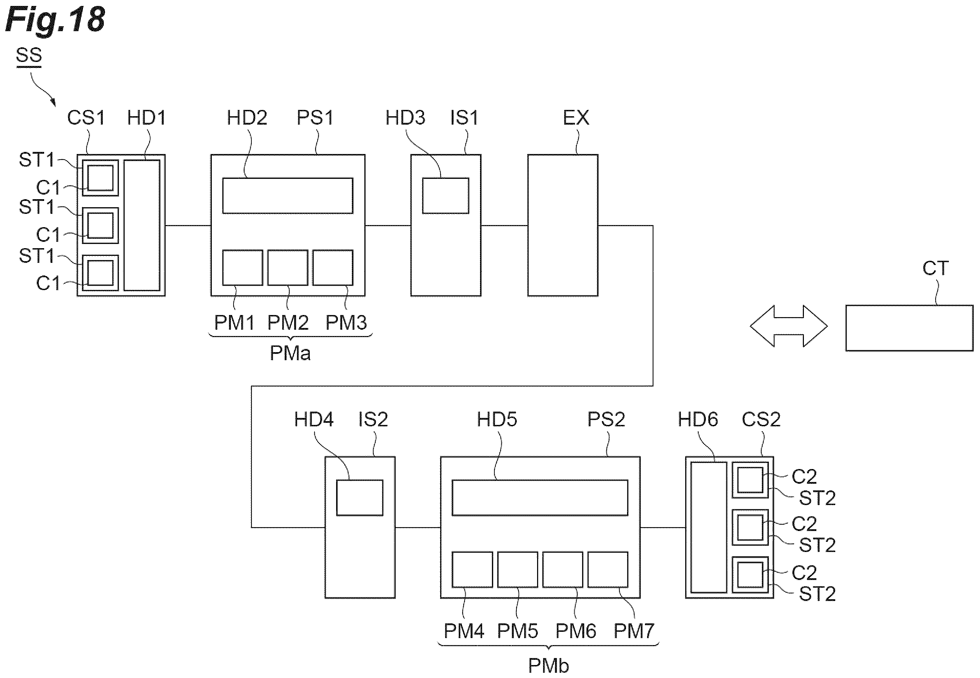

FIG. 18 is a diagram schematically showing a system SS for processing a substrate according to one exemplary embodiment. The system SS for processing a substrate includes a first carrier station CS1, a first processing station PS1, a first interface station IS1, an exposure device EX, a second interface station IS2, a second processing station PS2, a second carrier station CS2, and a controller CT.

The first carrier station CS1 performs the carrying-in and carrying-out of a first carrier C1 between the first carrier station CS1 and a system external to the system SS for processing a substrate. The first carrier station CS1 has a placing stand on which a plurality of first placing plates ST1 are provided. The first carrier C1 is placed on each first placing plate ST1. The first carrier C1 has a housing capable of accommodating the plurality of substrates W inside. The first carrier C1 is placed on each first placing plate ST1 in a state in which a plurality of substrates W are accommodated or in an empty state in which the first carrier C1 does not accommodate the substrate W. In one example, the first carrier C1 is a front opening unified pod (FOUP).

The first carrier station CS1 transports the substrate W between the first carrier C1 and the first processing station PS1. The first transport device HD1 is provided in the first carrier station CS1 to be positioned between the placing stand and the first processing station PS1. A second transport device HD2 is provided in the first processing station PS1. The first transport device HD1 transports the substrate W between the first carrier C1 on each first placing plate ST1 and the second transport device HD2 of the first processing station PS1. A load lock module may be provided between the first carrier station CS1 and the first processing station PS1. The load lock module can switch the pressure inside the load lock module to atmospheric pressure or vacuum. The "atmospheric pressure" may be a pressure inside the first transport device HD1. The "vacuum" may be a pressure lower than atmospheric pressure, for example, a medium vacuum of 0.1 Pa to 100 Pa. The inside of the second transport device HD2 may be atmospheric pressure or vacuum. The load lock module may transport the substrate W from the first transport device HD1, which is at atmospheric pressure, to the second transport device HD2, which is at vacuum, for example. The load lock module may transport, for example, the substrate W from the second transport device HD2, which is at vacuum, to the first transport device HD1, which is at atmospheric pressure.

The first processing station PS1 performs various types of processing on the substrate W. In one embodiment, the first processing station PS1 includes a pre-processing module PM1, a resist film forming module PM2, and a first heat treatment module PM3 (hereinafter, collectively referred to as a "first substrate processing module PMa"). The second transport device HD2 in the first processing station PS1 transports the substrate W. The second transport device HD2 transports the substrate W between the first substrate processing modules PMa. The second transport device HD2 transports the substrate W between the first processing station PS1 and the first carrier station CS1 or between the first processing station PS1 and the first interface station IS1.

The pre-processing module PM1 performs preprocessing on the substrate W. In one embodiment, the pre-processing module PM1 includes a temperature adjustment unit that adjusts the temperature of the substrate W or a high-precision temperature adjustment unit that adjusts the temperature of the substrate W with high precision. In one embodiment, the pre-processing module PM1 includes a hydrophobization processing unit that performs surface reforming processing on the substrate W. Each processing unit in the pre-processing module PM1 may be configured in a state in which the heat treatment apparatus 100 (refer to FIG. 1) and the plasma processing apparatus 1 (refer to FIGS. 2 and 3) are included.

The resist film forming module PM2 forms a resist film on the substrate W. In one embodiment, the resist film forming module PM2 includes a dry coating unit. The dry coating unit forms a resist film on the substrate W by using a dry process such as a vapor deposition method. The dry coating unit may include a CVD device or an atomic layer deposition (ALD) device that chemically vapor-deposits the resist film on the substrate W. Alternatively, the dry coating unit may include a physical vapor deposition (PVD) device that physically vapor-deposits the resist film. The dry coating unit may be the heat treatment apparatus 100 (refer to FIG. 1) or the plasma processing apparatus 1 (refer to FIGS. 2 and 3).

In one embodiment, the resist film forming module PM2 includes a wet coating unit. The wet coating unit forms a resist film on the substrate W by using a wet process such as a solution coating method.

In one embodiment, the resist film forming module PM2 includes both the wet coating unit and the dry coating unit.

The first heat treatment module PM3 performs a heat treatment on the substrate W. In one embodiment, the first heat treatment module PM3 includes any one or more of a pre bake (PAB) unit that performs a heating treatment on the substrate W on which the resist film is formed, a temperature adjustment unit that adjusts the temperature of the substrate W, and a high-precision temperature adjustment unit that adjusts the temperature of the substrate W with high precision. Each of these units may have one or a plurality of heat treatment apparatuses. The plurality of heat treatment apparatuses may be configured by stacking the heat treatment apparatuses. For example, the heat treatment apparatus may be the heat treatment apparatus 100 (refer to FIG. 1). The heat treatment may be performed at a predetermined temperature using a predetermined gas.

The first interface station IS1 has a third transport device HD3. The third transport device HD3 transports the substrate W between the first processing station PS1 and the exposure device EX. The third transport device HD3 has a housing that accommodates the substrate W. The third transport device HD3 may be configured such that the temperature, humidity, pressure, and the like in the housing are controllable.

In the exposure device EX, the resist film on the substrate W is exposed by using an exposure mask (reticle). The exposure device EX may be an EUV exposure device using EUV as a light source, for example.

The second interface station IS2 has a fourth transport device HD4. The fourth transport device HD4 transports the substrate W between the exposure device EX and the second processing station PS2. The fourth transport device HD4 has a housing that accommodates the substrate W. The fourth transport device HD4 may be configured such that the temperature, humidity, pressure, and the like in the housing are controllable.

The second processing station PS2 performs various types of processing on the substrate W. In one embodiment, the second processing station PS2 includes a second heat treatment module PM4, a measurement module PM5, a development module PM6, and a third heat treatment module PM7 (hereinafter, also collectively referred to as a "second substrate processing module PMb"). The second processing station PS2 has a fifth transport device HD5. The fifth transport device HD5 transports the substrate W. The fifth transport device HD5 transports the substrate W between the second substrate processing modules PMb. The fifth transport device HD5 transports the substrate W between the second processing station PS2 and the second carrier station CS2 or between the second processing station PS2 and the second interface station IS2.

The second heat treatment module PM4 performs a heat treatment on the substrate W. The second heat treatment module PM4 may include a post-exposure bake (PEB) unit that performs a heating treatment on the substrate W after exposure. The second heat treatment module PM4 may include a temperature adjustment unit that adjusts the temperature of the substrate W. The second heat treatment module PM4 may include a high-precision temperature adjustment unit that adjusts the temperature of the substrate W with high precision. Alternatively, the second heat treatment module PM4 may include any one or more of these. Each of these units may have one or a plurality of heat treatment apparatuses. The plurality of heat treatment apparatuses may be configured by stacking the heat treatment apparatuses. For example, the heat treatment apparatus may be the heat treatment apparatus 100 (refer to FIG. 1). The heat treatment may be performed at a predetermined temperature using a predetermined gas.

The measurement module PM5 measures the substrate W. In one embodiment, the measurement module PM5 includes an imaging unit including a placing stand on which the substrate W is placed, an imaging device, an illumination device, and various sensors (a temperature sensor, a reflectivity measuring sensor, and the like). The imaging device may be, for example, a CCD camera that images the appearance of the substrate W, or may be a hyperspectral camera that captures images by dispersing light into wavelengths. The hyperspectral camera can measure any one or more of a pattern shape, a dimension, a film thickness, a composition, and a film density of a resist film.

The development module PM6 performs development processing on the substrate W. In one embodiment, the development module PM6 includes a dry development unit that performs dry development on the substrate W. The dry development unit may be, for example, the heat treatment apparatus 100 (refer to FIG. 1) or the plasma processing apparatus 1 (refer to FIGS. 2 and 3).

The third heat treatment module PM7 performs a heat treatment on the substrate W. The third heat treatment module PM7 may include a post bake (PB) unit that performs a heating treatment on the substrate W after development. The third heat treatment module PM7 may include a temperature adjustment unit that adjusts the temperature of the substrate W. The third heat treatment module PM7 may include a high-precision temperature adjustment unit that adjusts the temperature of the substrate W with high precision. Alternatively, the third heat treatment module PM7 may include any one or more of these. Each of these units may have one or a plurality of heat treatment apparatuses. The plurality of heat treatment apparatuses may be configured by stacking the heat treatment apparatuses. For example, the heat treatment apparatus may be the heat treatment apparatus 100 (refer to FIG. 1). The heat treatment may be performed at a predetermined temperature using a predetermined gas.

The second carrier station CS2 performs the carrying-in and carrying-out of a second carrier C2 between the second carrier station CS2 and a system external to the system SS for processing a substrate. The configuration and the function of the second carrier station CS2 may be the same as those of the above-described first carrier station CS1.

The controller CT controls each configuration of the system SS for processing a substrate to perform the series of processing described above on the substrate W. The controller CT stores a recipe in which a procedure of a process, a condition of the process, a transportation condition, and the like are set. The controller CT controls each configuration of the system SS for processing a substrate according to the recipe. The controller CT may have some or all of the functions of each controller (the controller 200, the controller 2, and the controller 400) shown in FIGS. 1 to 4.

### [Example of Method for Processing Substrate]

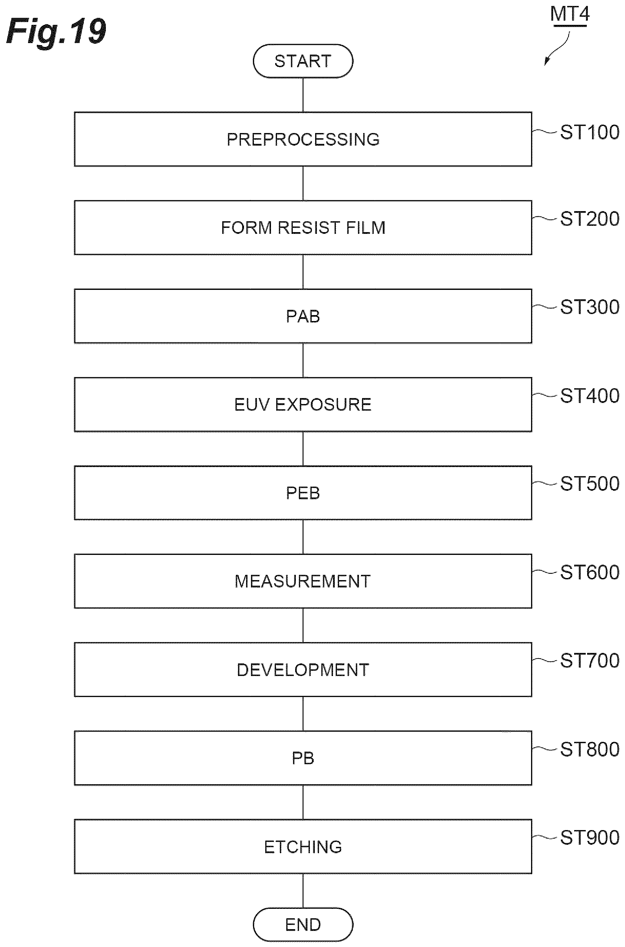

FIG. 19 is a flowchart of a method for processing a substrate (hereinafter, referred to as a "method MT4") according to one exemplary embodiment. As shown in FIG. 19, the method MT4 includes Step ST100 to Step ST900. Step ST100 is a step of performing preprocessing on the substrate. Step ST200 is a step of forming a resist film on the substrate W. Step ST300 is a step of performing a heating treatment (pre bake: PAB) on the substrate W on which the resist film is formed. Step ST400 is a step of exposing the substrate W to EUV light. Step ST500 is a step of performing a heating treatment (post exposure bake: PEB) on the substrate W after the exposure. Step ST600 is a step of performing measurement of the substrate W. Step ST700 is a step of developing the resist film on the substrate W. Step ST800 is a step of performing a heating treatment (post bake: PB) on the substrate W after development. Step ST900 is a step of etching the substrate W. The method MT4 may not include one or more of the above-described respective Steps. For example, the method MT4 may not include Step ST600, and Step ST700 may be performed after Step ST500.

The method MT4 may be performed by using the system SS for processing a substrate shown in FIG. 18. In the following description, a case where the controller CT of the system SS for processing a substrate controls each unit of the system SS for processing a substrate to perform the method MT4 on the substrate W will be described as an example.

### (Step ST100: Preprocessing)

First, the first carrier C1 accommodating the plurality of substrates W is carried into the first carrier station CS1 of the system SS for processing a substrate. The first carrier C1 is placed on the first placing plate ST1. Next, each substrate W in the first carrier C1 is sequentially taken out by the first transport device HD1, and transported to the second transport device HD2 of the first processing station PS1. The substrate W is transported to the pre-processing module PM1 by the second transport device HD2. The substrate W is subjected to preprocessing by the pre-processing module PM1. The preprocessing may include, for example, one or more of temperature adjustment of the substrate W, formation of some or all of an underlying film of the substrate W, a heating treatment of the substrate W, and high-precision temperature adjustment of the substrate W. The preprocessing may include the surface reforming processing of the substrate W.

### (Step S200: Resist Film Formation)

Next, the substrate W is transported to the resist film forming module PM2 by the second transport device HD2. The resist film is formed on the substrate W by the resist film forming module PM2. In one embodiment, the resist film is formed through a wet process such as a solution coating method. For example, the resist film is formed by spin-coating of the resist film on the substrate W using the wet coating unit of the resist film forming module PM2. In one embodiment, the formation of the resist film on the substrate W is performed by a dry process such as a vapor deposition method. For example, the resist film is formed by vapor-depositing the resist film on the substrate W using the dry coating unit of the resist film forming module PM2.

The formation of the resist film on the substrate W may be performed by using both the dry process and the wet process. For example, the second resist film may be formed on the first resist film by the wet process after the first resist film is formed on the substrate W by the dry process. In this case, the film thickness, the material, and the composition of the first resist film may be the same as or different from the film thickness, the material, and the composition of the second resist film.

### (Step ST300: PAB)

Next, the substrate W is transported to the first heat treatment module PM3 by the second transport device HD2. The substrate W is subjected to a heating treatment (pre bake: PAB) by the first heat treatment module PM3. The pre bake may be performed in an air atmosphere or an inert atmosphere. In the pre bake, the substrate W may be heated to 50°C or higher and 250°C or lower, may be heated to 50°C or higher and 200°C or lower, or may be heated to 80°C or higher and 150°C or lower. In a case where the resist film is formed by the dry process in Step ST200, the pre bake may be continuously performed by the dry coating unit that has performed Step ST200. In one embodiment, after the pre bake, processing of removing the resist film at the edge of the substrate W (edge bead removal: EBR) may be performed.

### (Step ST400: EUV Exposure)

Next, the substrate W is delivered to the third transport device HD3 of the first interface station IS1 by the second transport device HD2. Then, the substrate W is transported to the exposure device EX by the third transport device HD3. The substrate W is subjected to EUV exposure via the exposure mask (reticle) in the exposure device EX. As a result, on the substrate W, a first region where EUV exposure is performed and a second region where EUV exposure is not performed are formed corresponding to a pattern of the exposure mask (reticle).

### (Step ST500: PEB)

Next, the substrate W is transported from the fourth transport device HD4 in the second interface station IS2 to the fifth transport device HD5 in the second processing station PS2. Thereafter, the substrate W is transported to the second heat treatment module PM4 by the fifth transport device HD5 and is subjected to a heating treatment (post exposure bake: PEB). The post exposure bake may be performed in an air atmosphere. In the post exposure bake, the substrate W may be heated to 180°C or higher and 250°C or lower.

### (Step ST600: Measurement)

Next, the substrate W is transported to the measurement module PM5 by the fifth transport device HD5. The substrate W is measured by the measurement module PM5. The measurement may be an optical measurement. In one embodiment, the measurement by the measurement module PM5 includes measuring the appearance and the dimensions of the substrate W using a CCD camera. In one embodiment, the measurement by the measurement module PM5 includes measuring any one or more of a pattern shape, a dimension, a film thickness, a composition, and a film density of the resist film using the hyperspectral camera (hereinafter, also referred to as "pattern shape or the like").

In one embodiment, the controller CT determines the presence or absence of the exposure abnormality of the substrate W based on the measured appearance, dimension, pattern shape of the substrate W, and the like. In one embodiment, in a case where the controller CT determines that the exposure of the substrate W is abnormal, the substrate W may be reworked or discarded without performing the development in Step ST700. The rework of the substrate W may be performed by removing the resist on the substrate W and returning to Step ST200 to form a resist film again. By performing the rework before development, damage to the substrate W can be avoided or suppressed.

### (Step ST700: Development)

Next, the substrate W is transported to the development module PM6 by the fifth transport device HD5. In the development module PM6, the resist film of the substrate W is developed. The development processing may be performed by dry development. The development processing in Step ST700 may be performed by the method MT1 or the method MT2. Desorption processing may be performed once or more after the development processing or during the development processing. The desorption processing includes a step of removing (descumming) a scum from the surface of the resist film or a step of smoothing the surface with an inert gas such as helium or a plasma of the inert gas. In addition, in the development module PM6, after the development processing, a part of the underlying film UF may be etched using the developed metal-containing resist MF as a mask.

### (Step ST800: PB)

Next, the substrate W is transported to the third heat treatment module PM7 by the fifth transport device HD5 and is subjected to the heating treatment (post bake). The post bake may be performed in an air atmosphere or in a reduced pressure atmosphere containing N₂ or O₂. In the post bake, the substrate W may be heated to 150°C or higher and 250°C or lower. The post bake may be performed by the second heat treatment module PM4 instead of the third heat treatment module PM7. In one embodiment, the optical measurement of the substrate W may be performed by the measurement module PM5 after the post bake. This measurement may be executed in addition to the measurement in the Step ST600 or instead of the measurement in the Step ST600. In one embodiment, the controller CT determines the presence or absence of an abnormality such as a defect, a scratch, or an adhesion of a foreign matter in the developed pattern of the substrate W based on the measured appearance, dimensions, pattern shape of the substrate W, and the like. In one embodiment, in a case where the controller CT determines that an abnormality is present in the substrate W, the substrate W may be reworked or discarded without performing the etching in Step ST900. In one embodiment, in a case where the controller CT determines that an abnormality is present in the substrate W, the opening dimensions of the resist film of the substrate W may be adjusted by the dry coating unit (a CVD device, an ALD device, or the like).

### (Step ST900: Etching)

After the Step ST800 is performed, the substrate W is transported to a sixth transport device HD6 in the second carrier station CS2 by the fifth transport device HD5, and is transported to the second carrier C2 of the second placing plate ST2 by the sixth transport device HD6. Thereafter, the second carrier C2 is transported to the plasma processing system (not shown). In the plasma processing system, the underlying film UF of the substrate W is etched using the resist film after development as a mask. With this, the method MT3 ends. In a case where the resist film is developed using the plasma processing apparatus in Step ST700, the etching may be continuously performed in the plasma processing chamber of the same plasma processing apparatus as the development. In a case where the second processing station PS2 includes a plasma processing module in addition to the development module PM6, the etching may be performed in the plasma processing module included in the second processing station PS2. The desorption processing described above may be performed once or more before the etching or during the etching.

Various experiments performed for evaluating the method MT1 to the method MT3 are described below. The experiments described below do not limit the present disclosure.

### (First Experiment)

In the first experiment, a substrate having the same structure as the substrate W shown in FIG. 6 is prepared on a substrate support in a chamber. The metal-containing resist MF is an EUV resist and contains tin (Sn). The first film UF1 is an SOG film. The second film UF2 is an SOC film. The third film UF3 is a silicon oxide film.

Then, the first processing gas is supplied into the chamber without generating plasma (Step ST12). The first processing gas is a mixed gas of hydrogen fluoride gas (HF gas) and argon gas. The pressure in the chamber is 106.7 Pa (0.8 Torr). The partial pressure of the hydrogen fluoride gas is 88.9 Pa (0.67 Torr). The temperature of the substrate support is 120°C.

Then, the second processing gas is supplied into the chamber without generating plasma (Step ST13). The second processing gas is a mixed gas of silicon tetrachloride gas (SiCl₄ gas) and argon gas. The pressure in the chamber is 26.7 Pa (0.2 Torr). The partial pressure of the silicon tetrachloride gas is 2.4 Pa (0.02 Torr). A temperature of the substrate support is 120°C.

Thereafter, Step ST12 and Step ST13 are repeated such that Step ST12 and Step ST13 are each performed 5 times. The number of times each of Step ST12 and Step ST13 is performed is defined as the number of cycles.

### (Second Experiment)

The second experiment is performed in the same manner as in the first experiment except that Step ST13 and the repetition step are not performed. The processing time of Step ST12 is 240 seconds.

### (Third Experiment)

The third experiment is performed in the same manner as in the first experiment except that Step ST12 and the repetition step are not performed. The processing time of Step ST13 is 240 seconds.

### (Results of First Experiment)

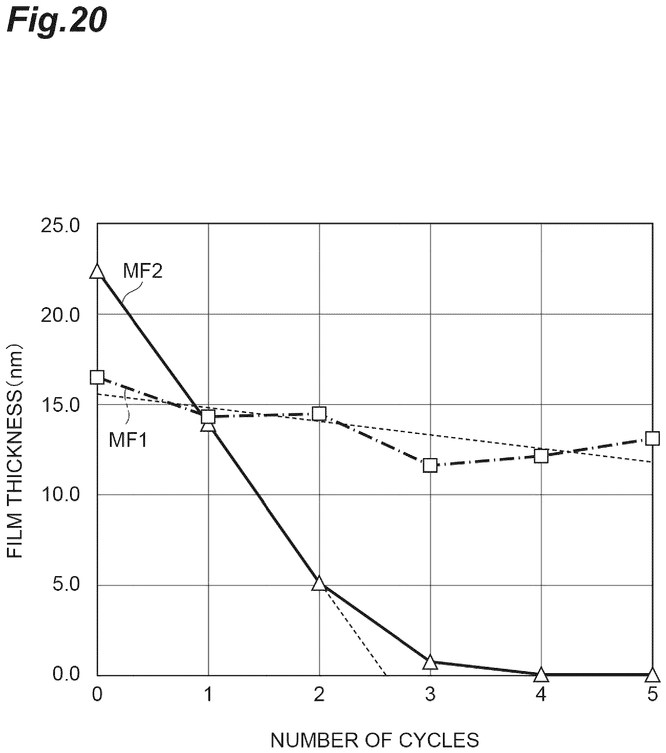

FIG. 20 is a graph showing an example of results of the first experiment. In FIG. 20, a horizontal axis indicates the number of cycles, and a vertical axis indicates film thicknesses of the first region MF1 and the second region MF2. As can be seen from FIG. 20, the film thickness of the second region MF2 decreases as the number of cycles increases, and is 0 nm in the fourth cycle. From this result, it can be understood that the second region MF2 can be completely removed without stopping the dry development in the middle. In FIG. 20, the dotted line is an approximate straight line of the results of each of the first region MF1 and the second region MF2. The film thickness removed per cycle of each of the first region MF1 and the second region MF2 is calculated from the approximate straight line. The film thickness of the first region MF1 removed per cycle was 0.8 nm/cycle. The film thickness of the second region MF2 removed per cycle was 9 nm/cycle. From this result, it can be understood that the second region MF2 can be removed with a high selectivity ratio with respect to the first region MF1.

### (Results of Second Experiment)

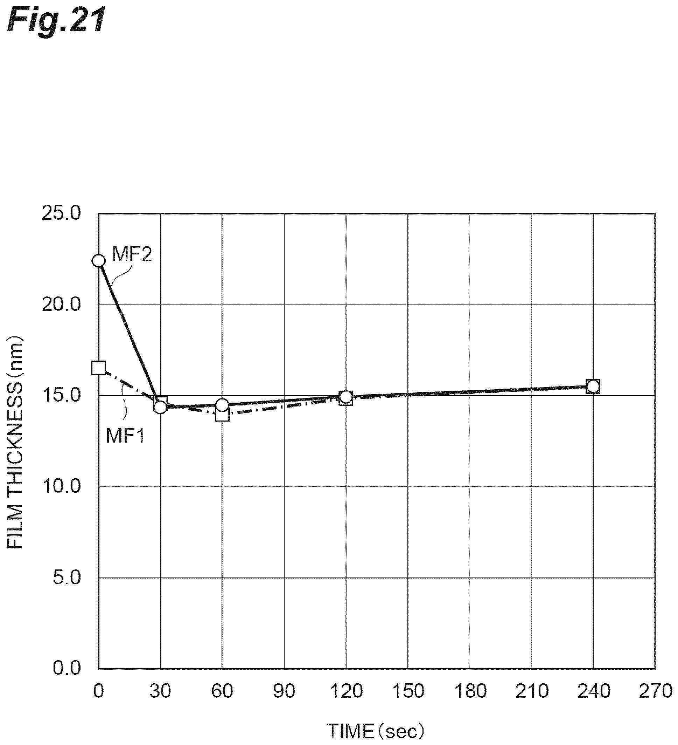

FIG. 21 is a graph showing an example of results of the second experiment. In FIG. 21, a horizontal axis indicates the time for supplying the processing gas, and a vertical axis indicates film thicknesses of the first region MF1 and the second region MF2. As can be seen from FIG. 21, the film thickness of the second region MF2 decreases up to about 30 seconds after the start of the supply of the processing gas, but then gradually increases. That is, in a case where Step ST13 is not performed, it can be understood that the dry development is stopped in the middle of the dry development, and the second region MF2 is not completely removed.

### (Results of Third Experiment)

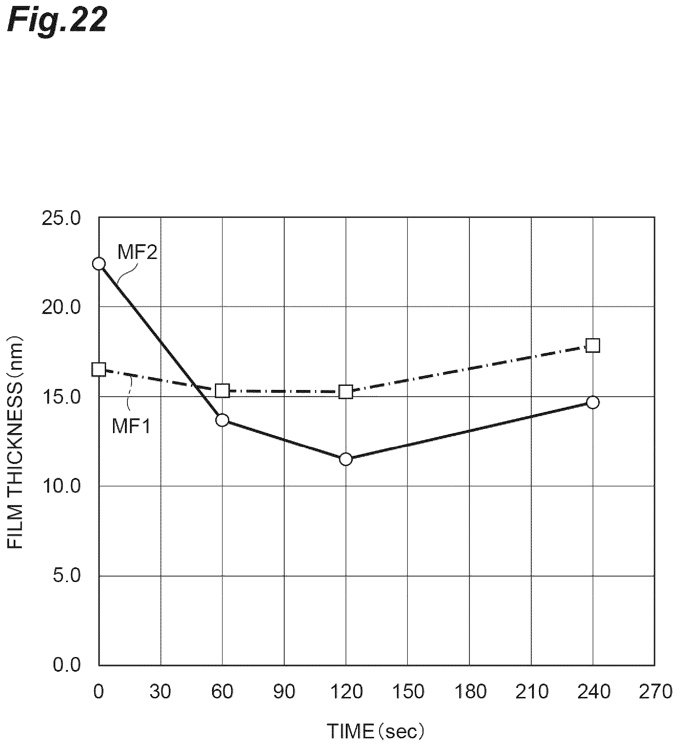

FIG. 22 is a graph showing an example of results of the third experiment. As can be seen from FIG. 22, the film thickness of the second region MF2 decreases up to about 120 seconds after the start of the supply of the processing gas, but then gradually increases. That is, in a case where Step ST12 is not performed, it can be understood that the dry development is stopped in the middle of the dry development, and the second region MF2 is not completely removed.

### (Fourth Experiment)

In the fourth experiment, a substrate including the metal-containing resist MF having the first region MF1 and the second region MF2 is prepared. Each of the first region MF1 and the second region MF2 has a line pattern in a top view. Then, a step of supplying a mixed gas of hydrogen fluoride gas and argon gas to the substrate is performed for 20 seconds. Thereafter, a step of supplying a mixed gas of silicon tetrachloride gas and argon gas to the substrate is performed for 20 seconds. In the fourth experiment, in a case where these two steps constitute one cycle, the number of cycles can be set from one cycle to six cycles. The temperature of the substrate support can be set at intervals of 20°C in a range of 60°C to 120°C. In the fourth experiment, dry development is performed after setting the number of cycles and the temperature of the substrate support. Thereafter, on the substrate after development, a width of a remaining line pattern of the first region MF 1 (line critical dimension (LCD)) and a variation in a width of the line pattern of the first region MF1 (line width roughness (LWR)) are measured.

### (Results of Fourth Experiment)

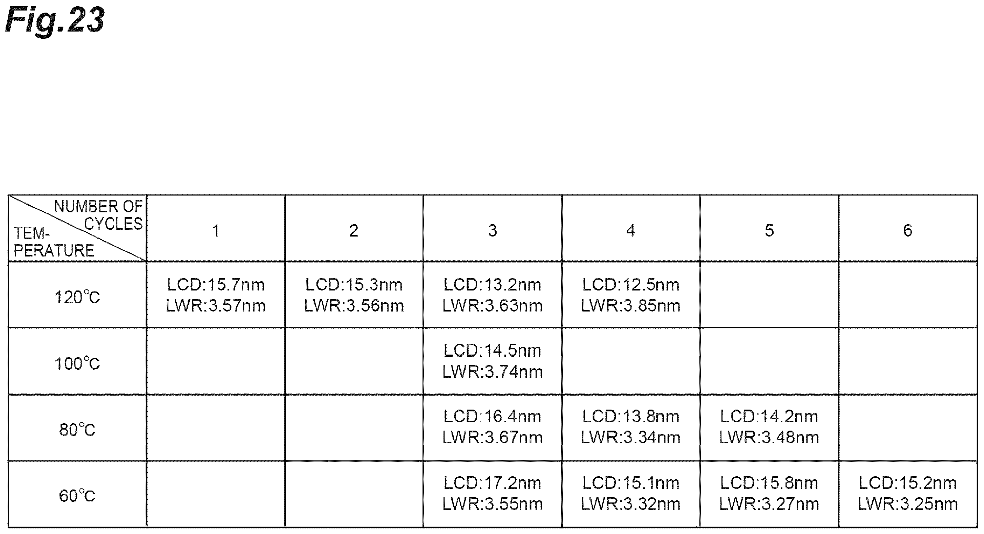

FIG. 23 is a table showing an example of results of the fourth experiment. In FIG. 23, horizontal items indicate the number of cycles, and vertical items indicate the temperature of the substrate support. For example, the measured values of the LCD and the LWR displayed at the top left indicate values measured under conditions in which the number of cycles is one cycle and the temperature of the substrate support is 120°C. From FIG. 23, it can be seen that in a case where the temperature of the substrate support is low, the LCD value increases and the LWR value decreases. In addition, it can be understood that, under the condition that the temperature of the substrate support is 60°C, the decrease in the value of the LCD and the increase in the value of the LWR are suppressed even in a case where the number of cycles is increased.

Here, the various exemplary embodiments included in the present disclosure are described in [E1] to [E23] below.

### [E1]

A dry development method including:
(a) providing a substrate on a substrate support in a chamber, substrate including an underlying film and a metal-containing resist on the underlying film, the metal-containing resist including an exposed first region and an unexposed second region;
(b) supplying a first processing gas including a fluorine-containing gas into the chamber to form a metal fluoride layer on a surface of the second region; and
(c) supplying a second processing gas including a chlorine-containing gas into the chamber to remove the metal fluoride layer.

### [E2]

The dry development method according to [E1], in which the metal-containing resist contains at least one selected from the group consisting of tin, hafnium, and titanium.

### [E3]

The dry development method according to [E1] or [E2], in which the metal-containing resist is an EUV resist.

### [E4]

The dry development method according to any one of [E1] to [E3], in which in the (b), the metal fluoride layer is generated without generating plasma.

### [E5]

The dry development method according to [E4], in which the fluorine-containing gas includes at least one selected from the group consisting of a hydrogen fluoride gas and a xenon fluoride gas.

### [E6]

The dry development method according to any one of [E1] to [E5], in which in the (b), the metal fluoride layer is generated by using plasma generated from the fluorine-containing gas.

### [E7]

The dry development method according to [E6], in which the fluorine-containing gas includes at least one selected from the group consisting of a hydrogen fluoride gas, a xenon fluoride gas, a nitrogen fluoride gas, a fluorocarbon gas, a hydrofluorocarbon gas, and a sulfur fluoride gas.

### [E8]

The dry development method according to any one of [E1] to [E7], in which in the (b), a temperature of the substrate support is 30°C or higher.

### [E9]

The dry development method according to any one of [E1] to [E8], in which the chlorine-containing gas includes at least one selected from the group consisting of a silicon tetrachloride gas, a titanium tetrachloride gas, a dimethylaluminum chloride gas, a thionyl chloride gas, and an acetyl chloride gas.

### [E10]

The dry development method according to any one of [E1] to [E9], in which in the (c), a temperature of the substrate support is 30°C or higher.

### [E11]

The dry development method according to any one of [E1] to [E10] further including (d) repeating the (b) and the (c).

### [E12]

The dry development method according to [E11],
in which the (d) includes changing at least one selected from the group consisting of a pressure in the chamber, a temperature of the substrate support, a processing time of the (b), and a processing time of the (c), in accordance with an aspect ratio of a recess formed in the metal-containing resist in the (c).

### [E13]

The dry development method according to [E11] or [E12],
in which the (d) includes executing at least one of reducing a pressure in the chamber, reducing a temperature of the substrate support, shortening a processing time of the (b), or shortening a processing time of the (c), in accordance with an increase in an aspect ratio of a recess formed in the metal-containing resist in the (c).

### [E14]

The dry development method according to any one of [E11] to [E13],
in which the (d) includes
a first period in which the (b) is executed in a first processing time and the (c) is executed in a second processing time, and
a second period in which the (b) is executed in a third processing time shorter than the first processing time and the (c) is executed in a fourth processing time shorter than the second processing time, after the first period.

### [E15]

The dry development method according to any one of [E11] to [E14],
in which in the (d),
one of the first processing gas and the second processing gas is continuously supplied into the chamber, and
the other of the first processing gas and the second processing gas is supplied into the chamber such that a first gas flow rate and a second gas flow rate, which is lower than the first gas flow rate, alternate.

### [E16]

The dry development method according to any one of [E1] to [E15],
in which the (b) includes
forming the metal fluoride layer without generating plasma, and
generating plasma from the first processing gas to form the metal fluoride layer.

### [E17]

The dry development method according to any one of [E1] to [E16] further including purging an internal space of the chamber after at least one of the (b) or the (c).

### [E18]

The dry development method according to any one of [E1] to [E17], in which a thickness of the second region removed in a direction from the metal-containing resist toward the underlying film is 5 nm or more and 20 nm or less per cycle including the (b) and the (c).

### [E19]

The dry development method according to any one of [E1] to [E18], in which a partial pressure of the chlorine-containing gas is 13.3 Pa or more and 13.3 kPa or less.

### [E20]

The dry development method according to any one of [E1] to [E19],
in which the (b) is performed at a first temperature, and
the (c) is performed at a second temperature higher than the first temperature.

### [E21]

A dry development method including:
(a) providing a substrate on a substrate support in a chamber, the substrate including an underlying film and a metal-containing resist on the underlying film, the metal-containing resist including an exposed first region and an unexposed second region; and
(b) supplying a processing gas including a fluorine-containing gas and a chlorine-containing gas into the chamber to remove the second region.

### [E22]

The dry development method according to [E21], in which the (b) includes reducing a pressure in the chamber in accordance with an increase in an aspect ratio of a recess formed in the metal-containing resist.

### [E23]

A dry development apparatus including:
a chamber;
a substrate support that supports a substrate in the chamber, the substrate including an underlying film and a metal-containing resist on the underlying film, the metal-containing resist including an exposed first region and an unexposed second region;
a gas supply configured to supply a first processing gas including a fluorine-containing gas and a second processing gas including a chlorine-containing gas into the chamber; and
a controller,
configured to control the gas supply to:
   supply the first processing gas into the chamber to form a metal fluoride layer on a surface of the second region; and
   supply the second processing gas into the chamber to remove the metal fluoride layer.

### Reference Signs List

1,100: dry development apparatus
10, 102: chamber (processing chamber)
11, 121: substrate support
2, 200: controller
20, 170: gas supply
UF: underlying film
MF: metal-containing resist
MF 1: first region
MF2: second region
MF21: metal fluoride layer
MT1, MT2, MT3: dry development method
W: substrate

## Claims

1. A dry development method comprising:
(a) providing a substrate on a substrate support in a chamber, substrate including an underlying film and a metal-containing resist on the underlying film, the metal-containing resist including an exposed first region and an unexposed second region;
(b) supplying a first processing gas including a fluorine-containing gas into the chamber to form a metal fluoride layer on a surface of the second region; and
(c) supplying a second processing gas including a chlorine-containing gas into the chamber to remove the metal fluoride layer.

2. The dry development method according to Claim 1,
wherein the metal-containing resist contains at least one selected from the group consisting of tin, hafnium, and titanium.

3. The dry development method according to Claim 1 or 2,
wherein the metal-containing resist is an EUV resist.

4. The dry development method according to Claim 1 or 2,
wherein in the (b), the metal fluoride layer is generated without generating plasma.

5. The dry development method according to Claim 4,
wherein the fluorine-containing gas includes at least one selected from the group consisting of a hydrogen fluoride gas and a xenon fluoride gas.

6. The dry development method according to Claim 1 or 2,
wherein in the (b), the metal fluoride layer is generated by using plasma generated from the fluorine-containing gas.

7. The dry development method according to Claim 6,
wherein the fluorine-containing gas includes at least one selected from the group consisting of a hydrogen fluoride gas, a xenon fluoride gas, a nitrogen fluoride gas, a fluorocarbon gas, a hydrofluorocarbon gas, and a sulfur fluoride gas.

8. The dry development method according to Claim 1 or 2,
wherein in the (b), a temperature of the substrate support is 30°C or higher.

9. The dry development method according to Claim 1 or 2,
wherein the chlorine-containing gas includes at least one selected from the group consisting of a silicon tetrachloride gas, a titanium tetrachloride gas, a dimethylaluminum chloride gas, a thionyl chloride gas, and an acetyl chloride gas.

10. The dry development method according to Claim 1 or 2,
wherein in the (c), a temperature of the substrate support is 30°C or higher.

11. The dry development method according to Claim 1 or 2, further comprising:
(d) repeating the (b) and the (c).

12. The dry development method according to Claim 11,
wherein the (d) includes changing at least one selected from the group consisting of a pressure in the chamber, a temperature of the substrate support, a processing time of the (b), and a processing time of the (c), in accordance with an aspect ratio of a recess formed in the metal-containing resist in the (c).

13. The dry development method according to Claim 11,
wherein the (d) includes executing at least one of reducing a pressure in the chamber, reducing a temperature of the substrate support, shortening a processing time of the (b), or shortening a processing time of the (c), in accordance with an increase in an aspect ratio of a recess formed in the metal-containing resist in the (c).

14. The dry development method according to Claim 11,
wherein the (d) includes
a first period in which the (b) is executed in a first processing time and the (c) is executed in a second processing time, and
a second period in which the (b) is executed in a third processing time shorter than the first processing time and the (c) is executed in a fourth processing time shorter than the second processing time, after the first period.

15. The dry development method according to Claim 11,
wherein in the (d),
one of the first processing gas and the second processing gas is continuously supplied into the chamber, and
the other of the first processing gas and the second processing gas is supplied into the chamber such that a first gas flow rate and a second gas flow rate, which is lower than the first gas flow rate, alternate.

16. The dry development method according to Claim 1 or 2,
wherein the (b) includes
forming the metal fluoride layer without generating plasma, and
generating plasma from the first processing gas to form the metal fluoride layer.

17. The dry development method according to Claim 1 or 2, further comprising:
purging an internal space of the chamber after at least one of the (b) or the (c).

18. The dry development method according to Claim 1 or 2,
wherein a thickness of the second region removed in a direction from the metal-containing resist toward the underlying film is 5 nm or more and 20 nm or less per cycle including the (b) and the (c).

19. The dry development method according to Claim 1 or 2,
wherein a partial pressure of the chlorine-containing gas is 13.3 Pa or more and 13.3 kPa or less.

20. The dry development method according to Claim 1 or 2,
wherein the (b) is performed at a first temperature, and
the (c) is performed at a second temperature higher than the first temperature.

21. A dry development method comprising:
(a) providing a substrate on a substrate support in a chamber, the substrate including an underlying film and a metal-containing resist on the underlying film, the metal-containing resist including an exposed first region and an unexposed second region; and
(b) supplying a processing gas including a fluorine-containing gas and a chlorine-containing gas into the chamber to remove the second region.

22. The dry development method according to Claim 21,
wherein the (b) includes reducing a pressure in the chamber in accordance with an increase in an aspect ratio of a recess formed in the metal-containing resist.

23. A dry development apparatus comprising:
a chamber;
a substrate support that supports a substrate in the chamber, the substrate including an underlying film and a metal-containing resist on the underlying film, the metal-containing resist including an exposed first region and an unexposed second region;
a gas supply configured to supply a first processing gas including a fluorine-containing gas and a second processing gas including a chlorine-containing gas into the chamber; and
a controller configured to control the gas supply to:
supply the first processing gas into the chamber to form a metal fluoride layer on a surface of the second region; and
supply the second processing gas into the chamber to remove the metal fluoride layer.
